(19) Europäisches Patentamt
European Patent Office
Office européen des brevets

(11) **EP 4 529 397 A1**

(12) **EUROPEAN PATENT APPLICATION**

(43) Date of publication:
**26.03.2025 Bulletin 2025/13**

(21) Application number: **24201539.4**

(22) Date of filing: **20.09.2024**

(51) International Patent Classification (IPC):
*H10K 59/122* (2023.01)   *H10K 59/124* (2023.01)
*H10K 59/80* (2023.01)

(52) Cooperative Patent Classification (CPC):
**H10K 59/878; H10K 59/122; H10K 59/124;
H10K 59/80521**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **25.09.2023 KR 20230128334**

(71) Applicant: **LG Display Co., Ltd.
Seoul 07336 (KR)**

(72) Inventors:
• **Lee, In Goo
  10845 Paju-si (KR)**
• **Nam, Seo Hyun
  10845 Paju-si (KR)**
• **Park, Se Hong
  10845 Paju-si (KR)**

(74) Representative: **Ter Meer Steinmeister & Partner
Patentanwälte mbB
Nymphenburger Straße 4
80335 München (DE)**

(54) **LIGHT EMITTING DISPLAY DEVICE**

(57)   Disclosed is a light emitting display device including a substrate including a plurality of subpixels, a first overcoat layer on an entire surface of the substrate, a second overcoat layer provided on the first overcoat layer and having a side surface overlapping a reflection area of each subpixel, a first electrode overlapping an emission area of each subpixel and provided on an upper surface of the second overcoat layer, an intermediate layer on the first overcoat layer, the second overcoat layer, and the first electrode, and a second electrode on the intermediate layer and having higher reflectance than the first electrode. Each subpixel is configured such that the reflection area is located outside the emission area, and the second electrode is located along the side surface of the overcoat layer in the reflection area to surround an end of the first electrode.

FIG. 2

EP 4 529 397 A1

## Description

This application claims the benefit of Korean Patent Application No. 10-2023-0128334, filed on September 25, 2023.

## BACKGROUND OF THE INVENTION

### Field of the Invention

The present disclosure relates to a light emitting display device, and more particularly, to a light emitting display device which may improve light extraction efficiency by extracting light lost in an optical waveguide mode to the outside of a substrate.

### Discussion of the Related Art

As society enters the information age, the field of display devices that visually display electrical information signals is developing rapidly. Accordingly, research in developing performance of various display devices, such as reduction in thickness, weight, and power consumption, is continuing.

Thereamong, a light emitting display device includes light emitting elements which are self-luminous elements, and does not require any separate light source used in non-light-emitting elements, thereby making it possible to reduce weight and thickness.

A light emitting element includes a first electrode, a second electrode, and an intermediate layer including various organic and/or inorganic materials between the first electrode and the second electrode, and emits light by applying an electric field between the first electrode and the second electrode. Here, light emitted from the intermediate layer may not escape to the outside of a substrate and may be trapped within the light emitting element, and thereby, light extraction efficiency with which light escapes to the outside of the substrate is reduced compared to the original luminous efficacy of the light emitting element.

Particularly, a portion of light formed in this process is trapped inside an optical waveguide mode formed by a refractive index difference between the first electrode and the intermediate layer. Thereby, all of light generated from the light emitting element does not escape to the outside of the substrate, thus resulting in decrease in light extraction efficiency.

## SUMMARY OF THE INVENTION

Accordingly, the present disclosure is directed to a light emitting display device that substantially obviates one or more problems due to limitations and disadvantages of the related art.

An object of the present disclosure is to provide a light emitting display device which may improve forward light extraction efficiency by extracting light trapped in the optical waveguide mode toward the front of a substrate.

Another object of the present disclosure is to provide a light emitting display device which may improve viewing angle characteristics by extracting light trapped in the optical waveguide mode also in the lateral direction.

At least one of these objects is solved by the features of the independent claim 1.

Additional advantages, objects, and features of the disclosure will be set forth in part in the description which follows and in part will become apparent to those having ordinary skill in the art upon examination of the following or may be learned from practice of the disclosure. The objectives and other advantages of the disclosure may be realized and attained by the structure particularly pointed out in the written description and claims hereof as well as the appended drawings.

A light emitting display device of the present disclosure causes the end of a first electrode to surround a second electrode in parabolic shape, thereby being capable of releasing light, which does not escape to the outside of a substrate among, light generated from an intermediate layer, and particularly releasing light in the optical waveguide mode.

According to an aspect of the disclosure, a light emitting display device includes a substrate including a plurality of subpixels, a first overcoat layer provided on an entire surface of the substrate, a second overcoat layer provided on the first overcoat layer in each of the plurality of subpixels and having a side surface configured to overlap a reflection area of each of the plurality of subpixels, a first electrode configured to overlap an emission area of each of the plurality of subpixels and provided on an upper surface of the second overcoat layer, an intermediate layer provided on the first overcoat layer, the second overcoat layer, and the first electrode, and a second electrode provided on the intermediate layer and configured to have higher reflectance than the first electrode. Each of the plurality of subpixels is configured such that the reflection area is located outside the emission area, and the second electrode is located along the side surface of the second overcoat layer in the reflection area to surround an end of the first electrode.

According to a further aspect, a light emitting display device comprises: a substrate comprising a plurality of subpixels; a first overcoat layer on an entire surface of the substrate; a second overcoat layer on the first overcoat layer, the second overcoat layer having a side surface to overlap a reflection area of each of the plurality of subpixels; a first electrode on an upper surface of the second overcoat layer at an emission area of each of the plurality of subpixels; an intermediate layer over the first overcoat layer, the second overcoat layer, and the first electrode; and a second electrode over the intermediate layer, the second electrode to have higher reflectance than the first electrode. The reflection area may be located outside the emission area. The second electrode may be located along the side surface of the second overcoat layer in the reflection area to surround an end of the first electrode.

According to a further aspect, a light emitting display device comprises: a substrate comprising a plurality of subpixels; an overcoat layer provided on the substrate, the overcoat layer comprising a flat area to overlap an emission area of each of the plurality of subpixels and a first concave area to surround the flat area and overlap a reflection area of each of the plurality of subpixels; a first electrode on the flat area of the overcoat layer; an intermediate layer provided on the overcoat layer and the first electrode; and a second electrode provided on the intermediate layer, the second electrode located along the first concave area of the overcoat layer to surround an end of the first electrode, wherein the second electrode has higher reflectance than the first electrode.

The light emitting device according to any one of the aspects may further include one or more of the following features:

The second electrode may surround an edge of the first electrode in a plan view the light emitting display device. In other words, the second electrode may cover or overlap the end and/or the edge of the first electrode. That is, an area of the second electrode may be larger than an area of the first electrode.

The side surface of the second overcoat layer may comprise a first side surface part adjacent to the upper surface of the second overcoat layer. The side surface of the second overcoat layer may comprise a second side surface part adjacent to a lower surface of the second overcoat layer. The second side surface part may have a different shape from the first side surface part.

The first side surface part may comprise a curve in a cross-sectional view.

The first side surface part may comprise a parabola in a cross-sectional view.

The reflection area may comprise a first reflection area provided with an area of the second electrode to follow a shape of the parabola of the first side surface part. The parabola may satisfy a following equation $-x^2=4ay$ (a is a constant greater than 0) to have a focus of coordinates (0,-a) at the end of the first electrode and a directrix of y=a and an x-axis is parallel to the first electrode, and a y-axis passes through the focus of the coordinates (0,-a).

The second side surface part may comprise a straight line in a cross-sectional view.

A first angle may be between the second side surface part of the second overcoat layer and the lower surface of the second overcoat layer. An angle between the first side surface part of the second overcoat layer and the lower surface of the second overcoat layer may be smaller than the first angle.

The upper surface of the second overcoat layer may comprise an area to overlap the first electrode.

A light emitting display device according to one aspect of present disclosure may further comprise a third overcoat layer between the second overcoat layer and the first electrode.

The third overcoat layer may comprise a first surface connected to the side surface of the second overcoat layer. The second electrode may be located along the first surface of the third overcoat layer in the reflection area.

The side surface of the second overcoat layer and the first surface of the third overcoat layer may have different shapes.

The first surface of the third overcoat layer may comprise a curve in cross-sectional view.

The first surface of the third overcoat layer may comprise a parabola.

The reflection area may comprise a first reflection area provided with an area of the second electrode to follow a shape of the parabola of the first surface. The parabola may satisfy a following Equation $-x^2=4ay$ (a is a constant greater than 0) to have a focus of coordinates (0,-a) at the end of the first electrode and a directrix of y=a; and an x-axis is parallel to the first electrode, and a y-axis passes through the focus of the coordinates (0,-a).

The third overcoat layer may further comprise a second surface to contact with the upper surface of the second overcoat layer. The third overcoat layer may further comprise a third surface to contact with a lower portion of an edge of the first electrode and to have a second angle with the second surface. In other words, the third surface may contact a lower portion of an edge of the first electrode. The third surface may form a second angle with the second surface.

The side surface of the second overcoat layer may comprise a straight line in a cross-sectional view.

A first angle may be between the side surface of the second overcoat layer and a lower surface of the second overcoat layer. An angle between the first surface and the second surface of the third overcoat layer may be smaller than the first angle.

The end of the first electrode may become thinner as a distance from a center of the first electrode increases.

The light emitting display device may further comprise color filters between the first overcoat layer and the substrate at the plurality of subpixels. Each of the color filters may overlap the emission area and the reflection area.

A light emitting display device according to an aspect of the present disclosure comprises a substrate comprising a plurality of subpixels; and an overcoat layer provided on the substrate, the overcoat layer having a flat area to overlap an emission area of each of the plurality of subpixels and a first concave area to surround the flat area and overlap a reflection area of each of the plurality of subpixels. The light emitting display device further comprises a first electrode provided on the flat area of the overcoat layer, an intermediate layer provided on the overcoat layer and the first electrode and a second electrode provided on the intermediate layer. The second electrode may be located along the first concave area of the overcoat layer to surround an end of the first electrode.

The second electrode may have higher reflectance than the first electrode.

The reflection area may comprise a first reflection area to overlap the first concave area of the overcoat layer. The reflection area may comprise a second reflection area located outside the first reflection area with respect to the flat area of the overcoat layer. The reflection area may comprise a third reflection area to overlap an edge of the flat area of the overcoat layer.

An area of the second electrode overlapping the first reflection area and an area of the second electrode overlapping the second reflection area may have different shapes.

The area of the second electrode overlapping the first reflection area may comprise a curve in a cross-section view.

The area of the second electrode overlapping the second reflection area may comprise a straight line in a cross-section view.

The first electrode may not overlap the reflection area.

The overcoat layer may further comprise a second concave area between the flat area and the first concave area to surround the flat area.

In light emitting display device according to one embodiment of present disclosure, the first electrode may have an area overlap a portion of the second concave area.

A light emitting display device according to an aspect of present disclosure comprises a substrate comprising a plurality of subpixels, thin film transistors provided on the substrate, an overcoat layer provided on an entire surface of the substrate and having at least one concave area, a first electrode spaced apart from the at least one concave area on the overcoat layer to correspond to each of the plurality of subpixels, an organic emission layer provided on the first electrode and a second electrode provided on the organic emission layer.

An emission area may be disposed where the first electrode is, and a reflected light emission area may be disposed where the first electrode is not. In other words, the first electrode may overlap with the emission area, but not overlap with the reflected light emission area.

At least one of the organic emission layer and the second electrode may be in direct contact with the overcoat layer at the reflected light emission area.

The reflected light emission area may surround at least three surfaces of the emission area.

The overcoat layer may have a first concave area. The reflected light emission area may be provided on a first inclined surface of the first concave area.

A light emitting display device according to an aspect of present disclosure may further comprise a plurality of wirings in a first direction on the substrate.

At least two of the plurality of wirings may overlap a portion of the reflected light emission area in the first direction.

The light emitting display device may further comprise a bank provided on the thin film transistors. The bank may cover the thin film transistors and may be in contact, preferably in direct contact, with the emission area in a second direction.

The overcoat layer may further comprise a flat surface. The overcoat layer may further comprise a second concave area having a second inclined surface configured to extend from the flat surface. The emission area including the second concave area may be greater than an area of the flat surface. The emission area including the second concave area may surround the flat surface.

The reflected light emission area may comprise a first reflection area, a second reflection area, and a third reflection area. The reflected light emission area may surround the emission area in order of the third reflection area, the first reflection area, and the second reflection area.

The light emitting display device may further comprise a plurality of wirings in a first direction on the substrate. The second reflection area may overlap at least two of the plurality of wirings.

It is to be understood that both the foregoing general description and the following detailed description of the present disclosure are exemplary and explanatory and are intended to provide further explanation of the disclosure as claimed.

BRIEF DESCRIPTION OF THE DRAWINGS

The accompanying drawings, which are included to provide a further understanding of the disclosure and are incorporated in and constitute a part of this application, illustrate embodiment(s) of the disclosure and together with the description serve to explain the principle of the disclosure. In the drawings:

FIG. 1 is a plan view of a light emitting display device according to an embodiment of the present disclosure;

FIG. 2 is a cross-sectional view taken along line I-I' of FIG. 1 according to an embodiment of the present disclosure;

FIG. 3 is an enlarged view of area A1 of FIG. 2 according to an embodiment of the present disclosure;

FIG. 4A is a diagram showing an optical waveguide path of the light emitting display device according to an embodiment of the present disclosure;

FIG. 4B is a diagram plotting a parabolic area of a second electrode in a coordinate system according to an embodiment of the present disclosure;

FIG. 5A is a cross-sectional view taken along line II-II' of FIG. 1 according to an embodiment of the present disclosure;

FIG. 5B is a cross-sectional view taken along line II-II' of FIG. 1, showing another embodiment of the present disclosure;

FIG. 6 is a plan view of a light emitting display device according to another embodiment of the present disclosure;

FIG. 7 is a cross-sectional view taken along line III-III' of FIG. 6 according to an embodiment of the present disclosure;

FIG. 8 is an enlarged view of area A2 of FIG. 7 according to an embodiment of the present disclosure;

FIG. 9A is a diagram showing an optical waveguide path of the light emitting display device according to an embodiment of the present disclosure;

FIG. 9B is a diagram plotting a parabolic area of a second electrode in a coordinate system according to an embodiment of the present disclosure; and

FIG. 10 is a graph showing light distribution in an optical waveguide mode according to an embodiment of the present disclosure.

## DETAILED DESCRIPTION OF THE INVENTION

The advantages and features of the present disclosure and methods of accomplishing the same will be clearly understood from the following preferred embodiments with reference to the attached drawings. However, the present disclosure is not limited to the embodiments, and may be embodied in different forms. The embodiments are suggested only to offer a thorough and complete understanding of the disclosed context and to sufficiently inform those skilled in the art of the technical concept of the present disclosure and embodiments of the present disclosure are only defined by the scope of the claims.

The shape, size, ratio, angle, number, and the like shown in the drawings to illustrate various embodiments of the present disclosure are merely provided for illustration, and the disclosure is not limited to the content shown in the drawings. Wherever possible, the same reference numbers will be used throughout the drawings to refer to the same or like parts. In the following description, detailed descriptions of technologies or configurations related to the present disclosure may be omitted so as to avoid unnecessarily obscuring the subject matter of the present disclosure.

When terms such as "including", "having", and "comprising" are used throughout the disclosure, an additional component may be present, unless "only" is used. A component described in a singular form encompasses a plurality thereof unless particularly stated otherwise.

The components included in the embodiments of the present disclosure should be interpreted to include an error range, even if there is no additional particular description thereof.

In describing the variety of embodiments of the present disclosure, when terms describing positional relationships such as "on", "above", "under" and "next to" are used, at least one intervening element may be present between the two elements, unless "immediately" or "directly" is also used.

In describing the variety of embodiments of the present disclosure, when terms related to temporal relationships, such as "after", "subsequently", "next", and "before", are used, the noncontinuous case may be included, unless "immediately" or "directly" is also used.

In describing the variety of embodiments of the present disclosure, terms such as "first" and "second" may be used to describe a variety of components, but these terms only aim to distinguish the same or similar components from one another. Accordingly, throughout the disclosure, a "first" component may be the same as a "second" component within the technical concept of the present disclosure, unless specifically mentioned otherwise.

The terms "first horizontal axis direction", "second horizontal axis direction", and "vertical axis direction" should not be interpreted as only geometric relationships in which the relationship between each other is vertical, and as having a broader range of direction as long as the configuration of the present disclosure can serve functionally.

The term "at least one" should be understood to include all possible combinations of one or more related items. For example, "at least one of the first, second, and third items" means each of the first, second, or third items, as well as any combination of two or more of the first, second, and third items.

Features of various embodiments of the present disclosure may be partially or completely coupled to or combined with each other, and may be variously inter-operated with each other and driven technically. The embodiments of the present disclosure may be carried out independently from each other, or may be carried out together in an interrelated manner.

In adding reference numerals to components in each drawing, identical components may have the same reference numerals as much as possible even if they are shown in different drawings. In addition, the scale of the components shown in the attached drawings has a different scale from the actual scale for convenience of explanation and is thus not limited to the scale shown in the drawings.

Hereinafter, exemplary examples of light emitting display devices according to embodiments of the present disclosure will be described in detail with reference to the accompanying drawings.

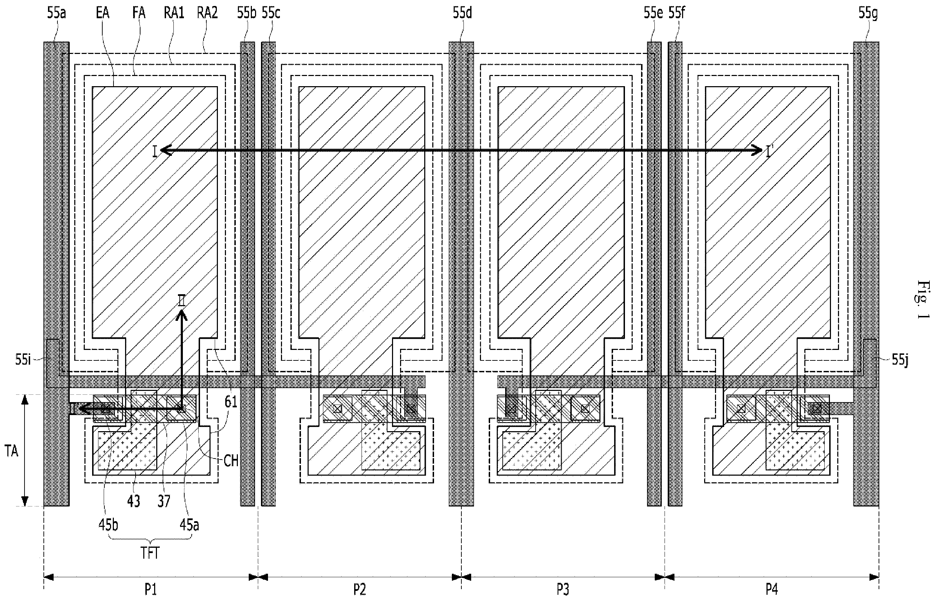

FIG. 1 is a schematic plan view of a light emitting display device 1 of the present disclosure according to an embodiment of the present disclosure.

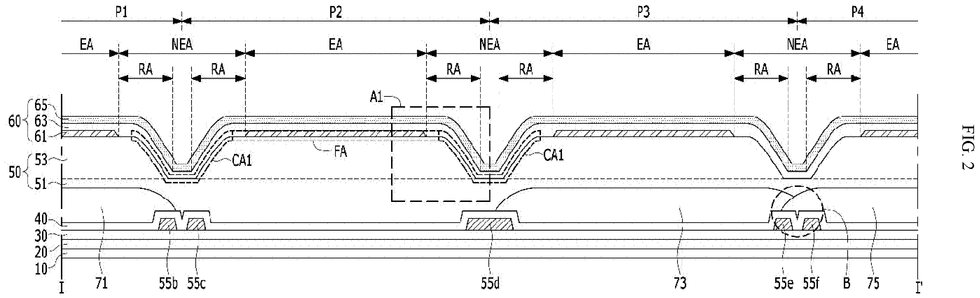

Referring to FIG. 1, the light emitting display device 1 may include first to ninth lines 55a, 55b, 55c, 55d, 55e, 55f, 55g, 55i, and 55j, and a thin film transistor TFT provided in each of a plurality subpixels P1, P2, P3, and P4 on a substrate 10 (in FIG. 2) provided with the plurality of subpixels P1, P2, P3, and P4.

The substrate 10 may be divided into an active area which displays images, and a non-active area which does not display images, and the active area may be formed by repeatedly arranging the plurality of subpixels P1, P2, P3, and P4. For example, if the substrate 10 is a plastic substrate, it may include polyimide or polyamide.

The plurality of subpixels P1, P2, P3, and P4 may emit light of different colors, and may emit red, white, green, and blue light, respectively. In some cases, the subpixel emitting white light may be omitted, and the subpixels emitting at least two of red light, green light, blue light, yellow light, magenta light, or blue-green light may be provided. However, the present disclosure is not limited thereto.

Although FIG. 1 illustrates that the plurality of subpixels P1, P2, P3, and P4 have the same area, the present disclosure is not limited thereto, the plurality of subpixels P1, P2, P3, and P4 may be formed to have different areas considering the light emission characteristics of the respective subpixels.

The plurality of subpixels P1, P2, P3, and P4 may be defined by gate lines and data lines which are formed in a matrix to intersect each other on the substrate 10. Further, in the present disclosure, power supply voltage lines configured to supply a high-voltage to the plurality of subpixels P1, P2, P3, and P4, and a reference voltage line configured to supply a reference voltage to the plurality of subpixels P1, P2, P3, and P4 may be provided. Referring to FIG. 1, the second line 55b, the third line 55c, the fifth line 55e, and the sixth line 55f may be the data lines, the first line 55a and the seventh line 55g may be the power supply voltage lines, and the fourth line 55d may be the power supply voltage line. The first to seventh lines 55a, 55b, 55c, 55d, 55e, 55f, and 55g may be arranged to be spaced apart from each other in one direction.

In addition, the eighth and ninth lines 55i and 55j may be provided in a direction which intersects the first to seventh lines 55a, 55b, 55c, 55d, 55e, 55f, and 55g. The eighth line 55i may be conductively connected to the first line 55a, and supply the power supply voltage of the first line 55a to the adjacent second subpixel P2. The ninth line 55j may be conductively connected to the seventh line 55g, and supply the power supply voltage of the seventh line 55g to the adjacent third subpixel P3. Also, the gate lines may be arranged in the direction intersecting the first to seventh lines 55a, 55b, 55c, 55d, 55e, 55f, and 55g.

A plurality of thin film transistors may be provided in each of the plurality of subpixels P1, P2, P3, and P4. For convenience of explanation, the present disclosure illustrates one thin film transistor TFT. That is, the present disclosure is not limited thereto, and a driving thin film transistor, a switching thin film transistor, a sensing thin film transistor, a capacitor, and the like may be provided to drive each subpixel.

The thin film transistor TFT may include a source electrode 45b, a drain electrode 45a, and a gate electrode 43. Upon receiving a data signal from the gate electrode 43, the thin film transistor TFT may supply driving voltage supplied from power supply voltage to a first electrode 61. Here, in the thin film transistor TFT, the first gate line 55a and the source electrode 45b may be connected to receive the power supply voltage, and when the thin film transistor TFT receives the data signal and thus the channel region of an active layer 37 is activated by the gate electrode 43, the thin film transistor TFT may control the power supply voltage though the drain electrode 45a connected to the first electrode 61 to be transmitted to the first electrode 61, thereby being capable of driving the corresponding subpixel.

Each of the plurality of subpixels P1, P2, P3, and P4 may include an emission area EA and a non-emission area NEA around the emission area EA. The emission area EA may be an area in which light is actually emitted, and specifically, light is generated from an intermediate layer 63 (e.g., light emitting layer) (in FIG. 2) by forming an electric field between the first electrode 61 and a second electrode 65 (in FIG. 2). The non-emission area NEA may be an area in which light is not actually emitted by the first electrode 61, the second electrode 65, and the intermediate layer 63.

Further, the emission area EA may overlap the patterned first electrode 61. In other words, a remained area in which the patterned first electrode 61 is provided on an overcoat layer 50 (in FIG. 2) may form the emission area EA. Meanwhile, a non-remained area in which the patterned first electrode 61 is not provided may form a reflected light emission area (e.g., reflection area) that reflects light from the emission area EA toward the substrate 10. Since the first electrode 61 is not provided in the patterned area, at least one of the intermediate layer 63 or the second electrode 65 may come into direct contact with the overcoat layer 50. Further, as the reflected light emission area, an area which partially overlap at least two lines (or wirings) of the first to seventh lines 55a, 55b, 55c, 55d, 55e, 55f, and 55g arranged in one direction may be provided (e.g., the area between two adjacent subpixels).

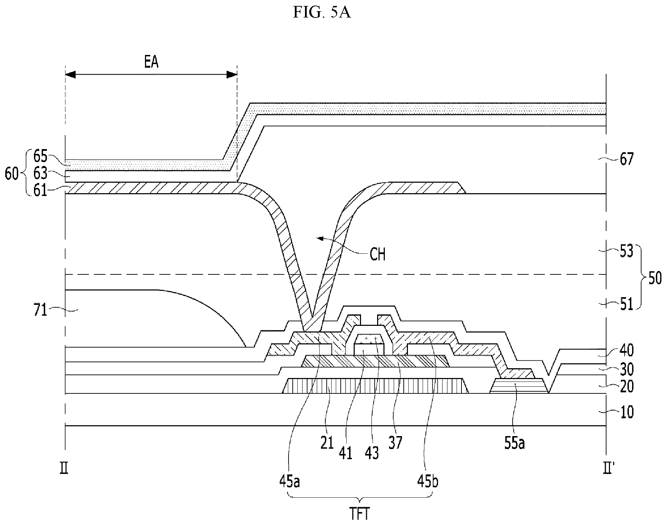

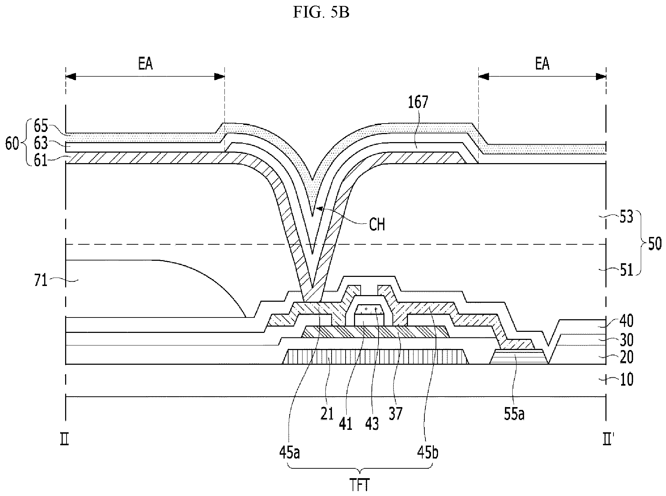

The emission area EA according to the first embodiment may be provided in a flat area FA having a flat surface in which the first electrode 61 is provided. That is, the emission area EA may overlap a portion of the flat area FA except for the edge of the flat area FA, and may overlap a portion of the first electrode 61 except for at least a contact hole CH of the first electrode 61. Specifically, the present disclosure may be provided with a bank 67 (in FIG. 5) having a minimum area which covers the edge of the first electrode 61. Here, an area, in which the bank 67 is formed, may define an opening and an area, in which the bank 67 is not formed, may define a non-opening portion. The bank 67 of the present disclosure may cover a thin film transistor area TA provided with the thin film transistor TFT in the non-opening portion. Further, the bank 67 may come into contact with the emission area EA in one direction in the opening. Accordingly, the remaining portion of the edge of the first electrode 61 excluding at least one side of the edge of the first electrode 61 may be exposed from the bank 67. Here, the area of the first electrode 61 covered by the bank 67 may be the area provided with the thin film transistor TFT, or may be at least an area of the contact hole CH connected to the thin film transistor TFT. The bank 67 will be descried in detail later in FIGs. 5A and 5B. Coming back, the present disclosure may prevent light emitted from the emission area EA from being refracted or lost by the bank 67 by exposing the edge of the first electrode 61 from the bank 67. Therefore, the present disclosure may extract light from a wider area than the emission area EA where light is actually emitted. That is to say, in the present disclosure, the area where light is extracted from the substrate 10 is not limited to the emission area EA, and may further include a portion of the non-emission area NEA around the emission area EA that can also extract light and redirect the light out of the display device.

In the present disclosure, the non-emission area NEA may have an area in which light is emitted. The light emitting display device according to the present disclosure may releases light, emitted from the emission area EA, to the non-emission areas NEA by the second electrode 65 surrounding the end of the first electrode 61. Here, the light emitting display device of the present disclosure may include an reflection area RA, in which light from the emission areas EA is reflected, within the non-emission areas NEA. Here, the reflection area RA may include the above-described reflected light emission area. In other words, the second electrode 65 can include a reflective material and at least a portion of the second electrode 65 disposed between adjacent first electrodes can be used to reflect more light out of the device. For example, light emitted in a lateral direction, which would otherwise be lost or trapped, can be reflected by the second electrode 65 and redirected out to the display device and towards a user.

The reflection area RA may be provided outside the flat area FA along the edge of the flat area FA. That is, the reflection area RA may be provided along the edge of the first electrode 61 to be spaced apart from the edges of the first electrode 61 and the emission area EA. The reflection area RA or the reflected light emission area may be formed to surround at least three surfaces of the emission area EA. In detail, the reflection area RA or the reflected light emission area may be formed to surround at least three surfaces of the flat area FA. That is, the reflection area RA may be omitted from a portion of the edge of the first electrode 61 corresponding to the area provided with the thin film transistor TFT. The reflection area RA is a component for light extraction, and may not be provided in the thin film transistor area TA, which may be an area in which light is not extracted in some cases. However, the present disclosure is not limited thereto, and the reflection area RA may be provided along all portions of the edge of the first electrode 61.

The reflection area RA may include a first reflection area RA1 and a second reflection area RA2 provided outside the first reflection area RA1. The first reflection area RA1 and the second reflection area RA2 may have different functions for light generated from the emission area EA. The first reflection area RA1 may reflect the light generated from the emission area EA in a forward direction that is perpendicular to the substrate 10. The second reflection area RA2 may reflect the light generated from the emission area EA in a lateral direction that intersects the substrate 10. Here, the direction intersecting the substrate 10 may be a direction moving toward the substrate 10 at an angle different from the forward direction. As such, as the first reflection area RA1 and the second reflection area RA2 have different functions, one of the first reflection area RA1 and the second reflection area RA2 may have a larger area depending on a direction in which light is to be extracted. For example, in the present disclosure, the second reflection area RA2 may be formed to have a larger area than the first reflection area RA1 to improve a viewing angle.

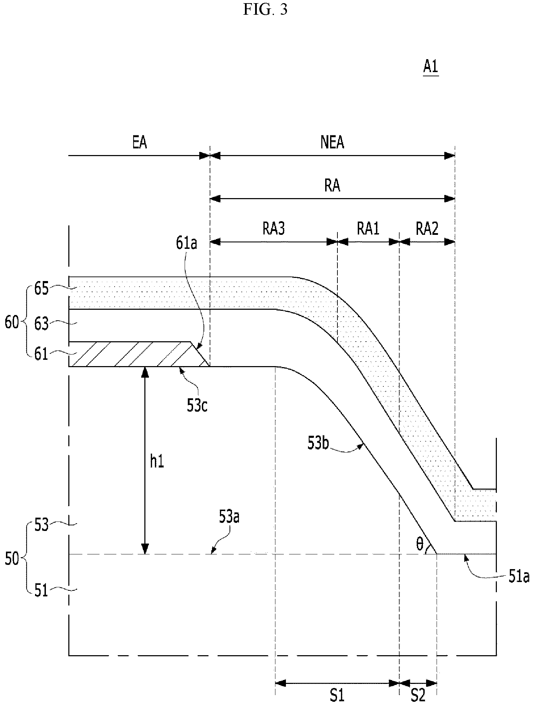

In addition, the reflection area RA may further include a third reflection area RA3 (in FIG. 3) between the first reflection area RA1 and the emission area EA. The third reflection area RA3 is located above the first electrode 61, and may reflect light generated from the emission area EA including an optical waveguide mode in the forward direction of the substrate 10. Such a third reflection area RA3 may include the flat area FA.

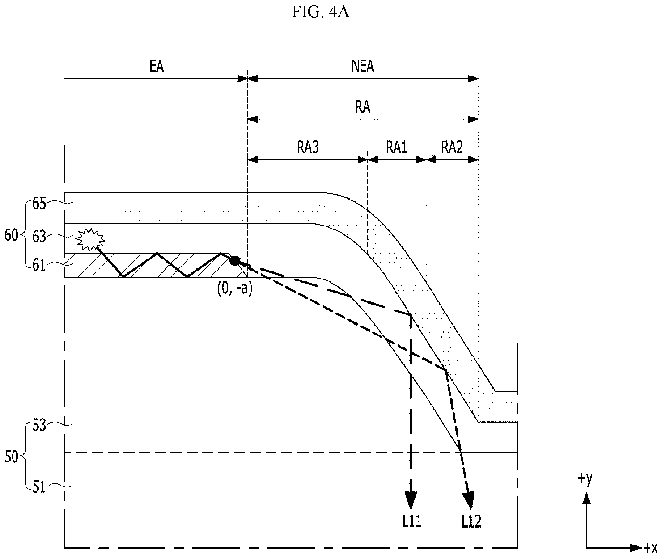

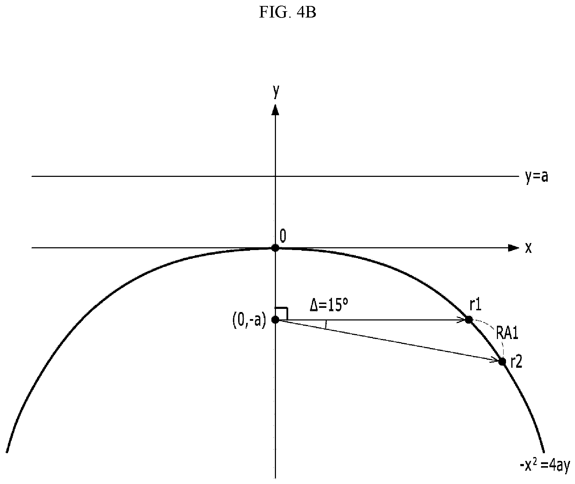

Hereinafter, the light emitting display device of the present disclosure according to the first embodiment will be described in detail with reference to FIGs. 2 to 5B. FIG. 2 is a cross-sectional view taken along line I-I' of FIG. 1 according to an embodiment of the present disclosure. FIG. 3 is an enlarged view of area A1 of FIG. 2 according to an embodiment of the present disclosure. FIG. 4A is a diagram showing an optical waveguide path of the light emitting display device according to an embodiment of the present disclosure, and FIG. 4B is a diagram plotting a parabolic area of a second electrode in a coordinate system according to an embodiment of the present disclosure. FIGs. 5A and 5B are cross-sectional views showing different embodiments, taken along line II-II' of FIG. 1.

Referring to FIG. 2, the light emitting display device according to one embodiment of the present disclosure may include the substrate 10 including the plurality of subpixels P1, P2, P3, and P4, a first overcoat layer 51 provided on the entire surface of the substrate 10, a second overcoat layer 53 on the first overcoat layer 51 in each of the plurality of subpixels P1, P2, P3, and P4, and having a side surface 53b overlapping the reflection area RA of each of the plurality of subpixels P1, P2, P3, and P4, the first electrode 61 provided on an upper surface 53c of the second overcoat layer 53 while overlapping the emission area EA of each of the plurality of subpixels P1, P2, P3, and P4, the intermediate layer 63 provided on the first overcoat layer 51, the second overcoat layer 53, and the first electrode 61, and the second electrode 65 provided on the intermediate layer 63 and having higher reflectance than the first electrode 61. The plurality of subpixels P1, P2, P3, and P4 may be configured such that the reflection area RA is located outside the emission area EA of each of the plurality of subpixels P1, P2, P3, and P4, and the second electrode 65 is located along the side surface 53b of the second overcoat layer 53 in the reflection area RA to surround an end 61a of the first electrode 61.

The light emitting display device according to the first embodiment of the present disclosure may include first, third, and fourth color filters 71, 73, and 75 in areas corresponding to the first, third, and fourth subpixels P1, P3, and P4 of the substrate 10, respectively, and may include light emitting elements 60 on an overcoat layer 50 which covers the first, third, and fourth color filters 71, 73, and 75. The second subpixel P2 without a color filter may be a subpixel which emits white light.

A buffer film 20, an interlayer insulating film 30, and a passivation layer 40 may be sequentially provided on the substrate 10 while interposing the transistors TFT and light-shielding layer 21 therebetween. The plurality of lines 55a, 55b, 55c, 55d, 55e, 55f, 55g, 55i, and 55j (in FIG. 1) may be provided between the interlayer insulating film 30 and the passivation layer 40. The plurality of lines 55a, 55b, 55c, 55d, 55e, 55f, 55g, 55i, and 55j may be located on the interlayer insulating film 30, and may be formed as the same layer as the source and drain electrodes 45b and 45a (in FIG. 5) of the thin film transistors TFTs.

The color filters 71, 73, and 75 corresponding to the first, third, and fourth subpixels P1, P3, and P4 may be provided on the passivation layer 40. As shown in FIG. 2, the second subpixel P2 may not have a color filter. In this case, the second subpixel P2 may be a subpixel which emits white light. If the first, third, and fourth subpixels P1, P3, and P4 emit light of specific colors, the first, third, and fourth subpixels P1, P3, and P4 may include the first, third, and fourth color filters 71, 73, and 75, respectively. As such, the first, third, and fourth subpixels P1, P3, and P4 may include the first, third, and fourth color filters 71, 73, and 75 which emit light of different colors. For example, the first color filter 71 may emit red light, the third color filter 73 may emit green light, and the fourth color filter 75 may emit blue light. However, the present disclosure is not limited thereto.

Each of the first, third, and fourth color filters 71, 73, and 75 may overlap at least the emission area EA of a corresponding one of the first, third, and fourth subpixels P1, P3, and P4. Further, each of the first, third, and fourth color filters 71, 73, and 75 may overlap a portion of the non-emission area NEA of the corresponding one of the first, third, and fourth subpixels P1, P3, and P4. At least, each of the first, third, and fourth color filters 71, 73, and 75 may overlap the reflection area RA among the non-emission area NEA of the corresponding one of the first, third, and fourth subpixels P1, P3, and P4. In the present disclosure, since the area in which light is emitted includes the emission area EA and the reflection area RA among the non-emission area NEA, each of the first, third, and fourth color filters 71, 73, and 75 may overlap at least the emission area EA and the reflection area RA of the corresponding one of the first, third, and fourth subpixels P1, P3, and P4.

Each of the first, third, and fourth color filters 71, 73, and 75 may overlap signal lines adjacent to the corresponding one of the first, third, and fourth subpixels P1, P3, and P4. For example, the first color filter 71 may overlap the first line 55a and the second line 55b, the third color filter 73 may overlap the fourth line 55d and the fifth line 55e, and the fourth color filter 75 may overlap the sixth line 55f and the seventh line 55g.

Referring to area B of FIG. 2, the third color filter 73 and the fourth color filter 75 corresponding to the third subpixel P3 and the fourth subpixel P4 located adjacent to each other may overlap each other to form a stacked structure. That is, if the corresponding subpixels are subpixels which emit light of colors other than white light, the corresponding color filters adjacent to each other may overlap each other so that one color filter is stacked on the other adjacent color filter. If the adjacent color filters overlap each other to form the stacked structure, as such, color mixing between the corresponding adjacent subpixels may be prevented. That is, in the present disclosure, adjacent color filters overlap each other to form a stacked structure, thereby being capable of exhibiting a function of preventing color mixing even if an area between the emission areas of corresponding adjacent subpixels is exposed from the bank (e.g., the overlapping portions of the color filters can provide a type of black matrix to block light).

The overcoat layer 50 may be provided on the entirety of the active area and the non-active area on the substrate 10. The overcoat layer 50 may cover the color filters 71, 73, and 75, the plurality of lines 55a, 55b, 55c, 55d, 55e, 55f, 55g, 55i, and 55j, the transistors TFT, etc. The overcoat layer 50 may be formed to have a thickness sufficient to flatten surface steps caused by components such as the transistors TFT on the substrate 10. For example, the overcoat layer 50 is a type of organic insulating film and may be one of photo acryl, polyimide, a benzocyclobutene resin, and acrylate, and in some cases, the overcoat layer 50 may be formed as a multilayer structure.

The first overcoat layer 51 and the second overcoat layer 53 may be formed of the same material in the same process. Alternatively, the first overcoat layer 51 and the second overcoat layer 53 may be formed of the same material in different processes. In some cases, the first overcoat layer 51 and the second overcoat layer 53 may be formed of different materials.

The overcoat layer 50 may have at least one concave area CA1. The overcoat layer 50 according to the first embodiment may include the first overcoat layer 51 and the second overcoat layer 53. Accordingly, the overcoat layer 50 including the first overcoat layer 51 and the second overcoat layer 53 may include the flat areas FA and the first concave areas CA1. For example, the concave area CA1 can be formed between adjacent subpixels. Also, portions of the second electrode 65 can follow the curves of the concave area CA1 to form the reflective area RA. Also, a cross-section of the reflective area RA can have a "V" shape or a "U" shape between adjacent subpixels.

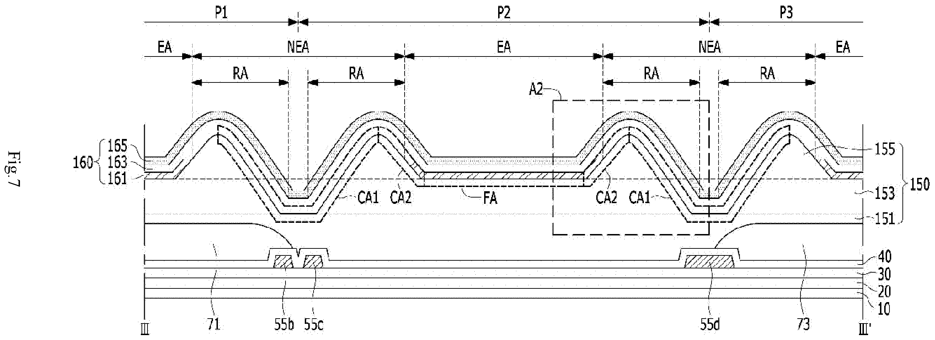

The flat area FA of the overcoat layer 50 is an area in which the surface of the second overcoat layer 53 is flat, and the first electrode 61 conductively connected to the thin film transistor TFT is provided thereon. As shown in FIG. 2, the first electrode 61 may have an area which overlaps a portion of the flat area FA. In other embodiment, for an example, as shown in FIG. 7, the first electrode 61 can have an area which overlaps with a portion of the flat area FA, and an area in which the first electrode 61 and the flat area FA do not overlap each other outside the area in which the first electrode 61 and the flat area FA overlap. However, the overlapping relationship between the first electrode 61 and the flat area FA is not limited thereto, and in some cases, the first electrode 61 is provided on the entirety of the flat area FA to completely overlap the flat area FA. The first electrode 61 may be provided on the flat area FA of the second overcoat layer 53, and thereby, the flat area FA may overlap the emission area EA. may thus

The first concave area CA1 of the overcoat layer 50 may be provided between adjacent flat areas FA. The first concave area CA1 may be an area which is recessed from the flat area FA of the second overcoat layer 53 toward a surface 51a of the first overcoat layer 51. Accordingly, the first concave area CA1 may have a first inclined surface which becomes a side surface of the second overcoat layer 53 in the recessed area connected to the flat area FA of the second overcoat layer 53. The first concave area CA1 can extend along three or more sides of a corresponding subpixel in a plan view. Here, the reflected light emission area may be provided on the first inclined surface of the first concave area CA1. Here, the reflected light emission area on the first inclined surface of the first concave area CA1 may be the inner surface of the second electrode 65 facing the first inclined surface of the first concave area CA1. As such, the first concave area CA1 may overlap the non-emission area NEA, and may overlap the reflection area RA outside the emission area EA. The first concave area CA1 described in the present disclosure may be a component differing from the contact hole CH (in FIG. 5A) formed for contact with an area surrounding the flat area FA.

Referring concurrently to FIG. 2 and FIG. 3, the first overcoat layer 51 may be provided on the entire surface of the substrate 10, and may come into contact with the surface of the passivation layer 40 and the surfaces of the first, third, and fourth color filters 71, 73, and 75. The surface 51a of the first overcoat layer 51 may be made flat by flattening the steps on the substrate 10.

The second overcoat layer 53 may be provided on the first overcoat layer 51 to correspond to each of the plurality of subpixels P1, P2, P3, and P4. The second overcoat layer 53 may be formed to protrude from the surface 51a of the first overcoat layer 51. The second overcoat layer 53 may be independently provided in each of the plurality of subpixels P1, P2, P3, and P4. Specifically, the second overcoat layer 53 may include a lower surface 53a in contact with the surface 51a of the first overcoat layer 51, the upper surface 53c opposite to the lower surface 53a, and the side surface 53b which connects the lower surface 53a and the upper surface 53c.

The lower surface 53a of the second overcoat layer 53 may overlap the emission area EA of each subpixel and the reflection area RA located outside the emission area EA. The upper surface 53c of the second overcoat layer 53 may overlap the emission area EA of each subpixel. Thereby, the side surface 53b between the upper surface 53c and the lower surface 53a of the second overcoat layer 53 may overlap at least a portion of the reflection area RA of each subpixel.

The upper surface 53c of the second overcoat layer 53 may be the flat area FA of the overcoat layer 50. The upper surface 53c of the second overcoat layer 53 may overlap a portion of the reflection area RA in addition to the emission area EA of each subpixel. The reflection area RA partially overlapping the upper surface 53c of the second overcoat layer 53 may include the third reflection area RA3.

The side surface 53b of the second overcoat layer 53 may overlap the first and second reflection areas RA1 and RA2 of each subpixel. Further, the side surface 53b of the second overcoat layer 53 may include a first side surface part S1 and a second side surface part S2 located outside the first side surface part S1. The first side surface part S1 of the second overcoat layer 53 may be located adjacent to the upper surface 53c, and the second side surface part S2 may be located adjacent to the lower surface 53a. Here, the side surfaces 53b in the first side surface part S1 and the second side surface part S2 of the second overcoat layer 53, respectively, may be formed to have different shapes.

The first side surface part S1 of the second overcoat layer 53 may be formed in a curve or to have a curved portion (e.g., a curved slope). Specifically, the first side surface part S1 of the second overcoat layer 53 may be formed in a parabola. The parabolic first side surface part S2 of the second overcoat layer 53 may correspond to the shape of the second electrode 65 in the first reflection area RA1 formed to follow a predetermined parabolic equation. In other words, the parabolic first side surface part S2 of the second overcoat layer 53 may be a basis for forming a parabolic shape for the second electrode 65 to extract the optical waveguide mode in the forward direction of the substrate 10.

The second side surface part S2 of the second overcoat layer 53 may be formed in a straight line or a straight slope. The straight second side surface part S2 of the second overcoat layer 53 may be a basis for forming a straight shape of the second electrode 65 overlapping the second reflection area RA2.

The second side surface part S2 of the second overcoat layer 53 may be formed at a first angle θ with respect to the lower surface 53a of the second overcoat layer 53. Since the side surface 53b of the second overcoat layer 53 becomes parabolic as it approaches the upper surface 53c, an angle formed by the first side surface part S1 of the second overcoat layer 53 and the lower surface 53a of the second overcoat layer 53 may be smaller than the first angle θ. Here, the first angle θ may be between 45° to 75° considering the light distribution characteristics of the optical waveguide mode which will be described below.

Meanwhile, as a vertical distance h1 between the upper surface 53c and the lower surface 53a of the second overcoat layer 53 increases, a straight area or straight sloped area may increase. Due to the characteristics of a parabola, a straight section may increase as the vertical distance h1 increases. Due to the nature of a parabola, an area adjacent to the origin o (in FIG. 4B) is formed in a curve, but the straight section may increase as the distance from the origin o increases. Therefore, an increase in the vertical distance h1 may lead to an increase in the second side surface part S2 having the straight slope. Further, since the increase in the straight section through the increase in the vertical distance h1 leads to an increase in a viewing angle extraction area, the non-emission area NEA increases compared to the emission area EA, and may thus reduce the lifespan of the light emitting display device. In order to prevent this problem, the vertical distance h1 may be set to an appropriate value or less. For example, the vertical distance h1 may be set to 3.5 μm or less.

The light emitting display device according to the present disclosure may determine the shapes of layers included in the light emitting elements 60 deposited on the second overcoat layer 53 depending on the shapes of the upper surface 53c and the side surface 53b of the second overcoat layer 53. The light emitting element 60 including the first electrode 61, the intermediate layer 63, and the second electrode 65 may be provided on the overcoat layer 50. The layers included in the light emitting element 60 may be formed of very thin organic films or metals having good step coverage, and may be deposited along the surface shape of the overcoat layer 50. Here, the light emitting element 60 may be a generally-used organic light emitting diode.

The first electrode 61 may be provided to correspond to each of the plurality of subpixels P1, P2, P3, and P4, and may be provided on the upper surface 53c of the second overcoat layer 53. The first electrode 61 may be spaced apart from at least one concave area of the overcoat layer 50. Therefore, the first electrode 61 according to the first embodiment may be spaced apart from the first concave area CA1. Specifically, the first electrode 61 may be provided to completely overlap the upper surface 53c of the second overcoat layer 53, or may be provided to overlap a portion of the upper surface 53c of the second overcoat layer 53. If the first electrode 61 overlaps a portion of the upper surface 53c of the second overcoat layer 53, the first electrode 61 may be provided to expose the edge of the upper surface 53c of the second overcoat layer 53 (e.g., the first electrode 61 may not overlap with an outer edge of upper surface 53c of the second overcoat layer 53 according to an embodiment). Providing the first electrode 61 not to overlap the edge of the upper surface 53c of the second overcoat layer 53 may be to form a certain free space (or margin) to form the first electrode 61 in the flat area FA from a process point of view. In addition, providing the first electrode 61 not to overlap the edge of the upper surface 53c of the second overcoat layer 53 may be an optical condition to reflect light emitted from the end 61a along the optical waveguide path in the first electrode 61 by the inner surface of the second electrode 65 to extract the light toward the front surface of the substrate 10 from an optical point of view.

The end 61a of the first electrode 61 may become thinner as it approaches the substrate 10 (e.g., end 61a of the first electrode 61 can taper to a point or have a sloped edge). Accordingly, the intermediate layer 63 of an organic material deposited on the first electrode 61 may be stably deposited on the inclined end 61a compared to a vertical end. In the case of the optical waveguide mode, the shape of the end 61a of the first electrode 61 may not directly affect the effect that light in the optical waveguide mode emitted from the end 61a is reflected toward the front surface of the substrate 10 by the first reflection area RA1.

Further, the light emitting display device according to the present disclosure may be formed in a bottom emission type in which light emitted from the intermediate layer 63 is emitted toward the substrate 10 on which the transistors TFT are provided. Accordingly, the first electrode 61 may be formed as a conductive layer formed of a transparent material. For example, the first electrode 61 may be formed of a transparent conductive material, such as indium-tin-oxide (ITO) or indium zinc oxide (IZO).

The intermediate layer 63 on the first electrode 61 may be provided over the entire area of the substrate 10, e.g., laid down as a common layer. In the present disclosure, the intermediate layer 63 may include an organic material, and may be a general organic light emitting layer. Specifically, the intermediate layer 63 may mean an organic layer of a single stack including multiple layers including a hole injection layer (HIL), a hole transport layer (HTL), an emission layer (EML), an electron transport layer (ETL), and an electron injection layer (EIL). In some cases, the intermediate layer 63 may have a tandem structure including a plurality of stacks, i.e., a first stack and a second stack, each of which includes an emission layer, and a charge generation layer CGL between the stacks. Further, the tandem structure of the intermediate layer 63 is not limited to a two-stack structure, and may include a plurality of stacks, i.e., three or more stacks.

In the plurality of stacks, the respective emission layers may be emission layers which emit light of the same color, i.e., any one of red, green, and blue light, and may be provided in each of some of the plurality of subpixels P1, P2, P3, and P4. Other layers included in the intermediate layer 63 excluding the emission layers may be provided over the entire surface of the substrate 10 through common masks. Alternatively, when emitting white light through emission layers in a two-stack structure or a multiple stack structure including three or more stacks, each of the emission layers may be provided over the entire surface of the substrate 10 through a common mask in the same manner as the other layers included in the intermediate layer 63.

The charge generation layer may be formed in a double-layer structure including an n-type charge generation layer and a p-type charge generation layer. The n-type charge generation layer and the p-type charge generation layers of the charge generation layer may include an n-type dopant and a p-type dopant, respectively.

The second electrode 65 on the intermediate layer 63 may be provided over the entire surface of the substrate 10 through a common mask. The second electrode 65 may be laid down as a common layer., e.g., laid down as a common layer. The second electrode 65 may be formed to have higher reflection efficiency than the first electrode 61 to reflect light generated from the intermediate layer 63. For example, the second electrode 65 may be formed in a multilayer structure including a transparent conductive film and an opaque conductive film having high reflection efficiency. The transparent conductive film of the second electrode 65 may be formed of a material having a relatively high work function value, such as indium tin oxide (ITO) or indium zinc oxide (IZO), and the opaque conductive film may be formed as a single-layer or multilayer structure including at least one selected from the group consisting of silver (Ag), aluminum (Al), copper (Cu), molybdenum (Mo), titanium (Ti), nickel (Ni), chromium (Cr), tungsten (W), and alloys thereof. For example, the second electrode 65 may be formed in a structure in which a transparent conductive film, an opaque conductive film, and a transparent conductive film are sequentially stacked, or in a structure in which a transparent conductive film and an opaque conductive film are sequentially stacked.

The second electrode 65 may be provided along the shapes of the upper and side surfaces 53c and 53b of the second overcoat layer 53 and the surface 51a of the overcoat layer 51. The second electrode 65 may be located along the side surface 53b of the second overcoat layer 53 in the reflection area RA to surround the end 61a of the first electrode 61. Accordingly, the second electrode 65 provided in the reflection area RA may reflect light, which travels laterally, among light generated from the emission area EA, toward the substrate 10.

In the present disclosure, the second electrode 65 may be formed along the surface shape of the overcoat layer 50, but due to the thickness of the intermediate layer 63 interposed between the overcoat layer 50 and the second electrode 65, the parabolic area of the second electrode 65 may be shifted outwards from the parabolic area of the overcoat layer 50 by the thickness of the intermediate layer 63. That is, the first reflection area RA1 representing the parabolic area of the second electrode 65 may not completely overlap the first side surface part S1 of the overcoat layer 50, and the first reflection area RA1 may be shifted outwards from the first side surface part S1 while overlapping a portion of the first side surface part S1.

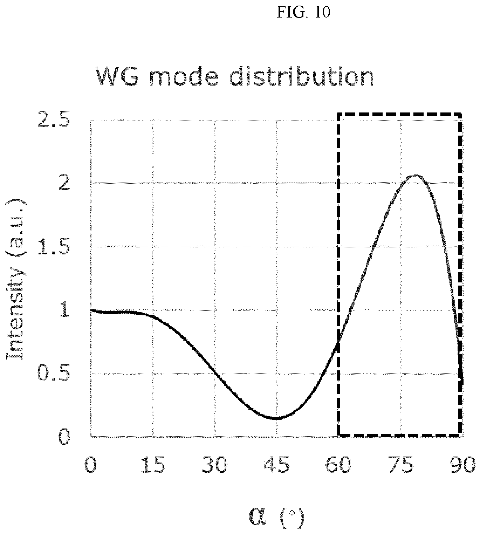

Hereinafter, light distribution in the optical waveguide mode will be described in detail with reference to FIG. 10. In a graph shown in FIG. 10, the horizontal axis represents an angle at which the optical waveguide mode proceeds with respect to the substrate 10, and the vertical axis represents the light intensity of the optical waveguide mode. Referring to FIG. 10, the optical waveguide mode may proceed toward the front and side surfaces of the substrate 10, the angle of light, which travels parallel to the substrate 10, may be defined as 90° based on 0° as the angle of light, which travels perpendicular to the substrate 10. Further, in the optical waveguide mode, on the assumption that the intensity of light travelling at an angle of 0°, i.e., in the forward direction of the substrate 10, is set to 1, the intensities of light traveling at other angles are expressed relative thereto. Specifically, the optical waveguide mode may have a light intensity of 1 or less at angles between 0° to 45°, and may have a light intensity of 2 or more at angles between 45° to 90°. Particularly, the optical waveguide mode may have a light intensity of 2 at an angle of about 75°, which exhibits the best efficiency. Looking at an area where a curve is surrounded by the horizontal and vertical axes in the graph of FIG. 10, light intensities in the range of angles from 0° to 45° may occupy about 35% of the total light intensity in the optical waveguide mode, and light intensities in the range of angles from 45° to 90° may occupy about 65% of the total light intensity in the optical waveguide mode. Accordingly, it may be seen that the optical waveguide mode mostly proceeds at angles of 45° or more. Particularly, it may be seen that the optical waveguide mode mostly proceeds at angles from 75° to 90°.

Accordingly, the present disclosure may be provided with the second electrode 65 to extract light in the optical waveguide mode to the substrate 10 in an area of angles from 75° to 90°, where the efficiency of the optical waveguide mode is the best.

Referring to FIG. 4A, the second electrode 65 is formed in a parabola satisfying the following Equation 1 at least in the first reflection area RA1, thereby being capable of reflecting light in the optical waveguide mode among light, which is generated from the emission area EA and travels laterally, in the forward direction L11 of the substrate 10. That is, referring to FIG. 4A, the optical waveguide mode emitted from one focus (0,-a) of the end 61a of the first electrode 61 may proceed in the forward direction L11 of the substrate 10, which is perpendicular to the substrate 10, by the second electrode 65 corresponding to the first reflection area RA1.

$$\text{Equation 1: } -x^2 = 4ay \text{ (a is a constant greater than 0)}$$

Referring concurrently to FIG. 4B, Equation 1 may satisfy conditions in which the focus has the coordinates (0,-a) at the end 61a of the first electrode 61, y=a is a directrix, and a is a constant greater than 0. Here, the x-axis may be parallel to the first electrode 61. Further, the end 61a of the first electrode 60 may be a point from which which the optical waveguide mode light is emitted, and the point from which the optical waveguide mode is emitted may mean the focus (0,-a) for the parabolic equation of Equation 1. r1 and r2 shown in FIG. 4B are points where light in the optical waveguide mode traveling in the 90° direction and light in the optical waveguide mode travelling in the 75° direction shown in FIG. 10 meet a parabola following Equation 1, respectively. A parabolic area between r1 and r2 may have the effect of extracting the optical waveguide mode in the forward direction of the substrate 10, which is the direction perpendicular to the substrate 10. That is, the second electrode 65 provided in the first reflection area RA1 of the present disclosure may have a parabolic shape corresponding to the reflection area RA1 shown in FIG. 4B. Accordingly, in the present disclosure, the optical waveguide mode emitted from the end 61a of the first electrode 61 is extracted in the forward direction of the substrate 10 through the second electrode 65 provided in the first reflection area RA1 surrounding the end 61a of the first electrode 61, thereby further improving forward light extraction efficiency of the light emitting display device.

An area of the second electrode 65 corresponding to the second reflection area RA2 may reflect the optical waveguide mode in the lateral direction L12 of the substrate 10. The straight area of the second electrode 65 overlapping the second reflection area RA2 of the second electrode 65 may be a straight section of the parabola extending toward the second reflection area RA2 depending on Equation 1 for the parabola of the second electrode 65 overlapping the first reflection area RA1. In some cases, the second side surface part S2 of the second overcoat layer 53 may be formed as a straight line which does not follow Equation 1 for the parabola of the first side surface part S1. In the present disclosure, the area of the second electrode 65 in the second reflection area RA2 will be described as a straight section following Equation 1, as an example.

Since the area of the second electrode 65 corresponding to the second reflection area RA2 is formed along the shape of the side surface 53b of the second overcoat layer 53, the angle of the straight area of the second electrode 65 with the substrate 10 may be the first angle θ. The first angle θ may satisfy the following Equation 2.

$$\text{Equation 2: } \theta = (180 - \alpha)/2$$

Here, α may mean the progress angle of the optical waveguide mode in FIG. 10. In the present disclosure, the optical waveguide mode has the best efficiency at angles of 75° to 90°, and the optimal condition of the first angle θ may be derived by substituting these angles for α. By substituting 75° and 90° for α in Equation 2, respectively, the optimal condition of the first angle θ may be the range of 45° to 52.5°. In addition, referring to FIG. 10, if the progress angle of the optical waveguide mode with the maximum efficiency is about 75°, the first angle θ may be 52.5°. That is, the light emitting display device of the present disclosure may extract the optical waveguide mode with the highest efficiency in the forward direction of the substrate 10, when the angle between the area of the second electrode 65 corresponding to the second reflection area RA2 and the substrate 10 is in the range of 45° to 52.5°. In addition, the light emitting display device of the present disclosure may achieve the maximum efficiency in extraction of the optical waveguide mode in the forward direction of the substrate 10, when the angle between the area of the second electrode 65 corresponding to the second reflection area RA2 and the substrate 10 is 52.5°. However, the first angle θ of the present disclosure is not limited thereto, and may be less than 45° or greater than 52.5° to extract light in the optical waveguide mode.

An area of the second electrode 65 corresponding to the third reflection area RA3 may guide the optical waveguide mode toward the front surface of the substrate 10. The area of the second electrode 65 corresponding to the third reflection area RA3 may be located above the first electrode 61. When light as an optical waveguide mode component emitted from the first electrode 61 is reflected by the area of the second electrode 65 in the third reflection area RA3, the light may be reflected at half the exit angle of the light and reach the area of the second electrode 65 corresponding to the first reflection area RA1 or the second reflection area RA2. As a result, the light as the optical waveguide mode component reflected by the area of the second electrode 65 in the third reflection area RA3 may be reflected again by the area of the second electrode 65 corresponding to the first reflection area RA1 or the second reflection area RA2, and may be emitted in the forward direction of the substrate 10. Therefore, the area of the second electrode 65 in the third reflection area RA3 may indirectly reflect and extract light traveling in the upward direction opposite to the front surface of substrate 10, among light generated from the emission area EA, toward the substrate 10.

As such, the light emitting display device of the present disclosure is configured such that the second electrode 65 surrounds the end 61a of the first electrode 61, and the optical waveguide mode emitted from the end 61a of the first electrode 61 may be released toward the substrate 10. Particularly, since the parabolic area of the second electrode 65, which corresponds to the first reflection area RA1 and satisfies Equation 1, may reflect the optical waveguide mode in the forward direction L11 (in FIG. 4A) of the substrate 10, the light emitting display device according to the present disclosure may have the effect of significantly improving forward light extraction efficiency and making each subpixel brighter. Further, since the straight area of the second electrode 65 corresponding to the second reflection area RA2 may reflect the optical waveguide mode in the lateral direction L12 (in FIG. 4A) of the substrate 10, the light emitting display device according to the present disclosure may have the effect of improving a viewing angle (e.g., the subpixels can be made brighter but also provide a wider viewing angle, save space and reduce power consumption). For example, the subpixels can be packed closer together and a higher resolution can be provided.

Referring to FIGs. 5A and 5B, the bank 67 or 167 of the present disclosure may be provided to cover the contact hole CH formed in the overcoat layer 50. That is, the bank 67 or 167 of the present disclosure may be provided above the thin film transistor TFT provided with the contact hole CH at the end of the first electrode 61.

The thin film transistor TFT will be described in detail. The thin film transistor TFT of the present disclosure includes the active layer, the gate electrode 43 overlapping the channel region of the active layer 37 by interposing the gate insulating film 41 therebetween, and the source electrode 45b and the drain electrode 45a connected to both sides of the active layer 37.

The active layer 37 of the thin film transistor TFT may have a source region and a drain region on both sides thereof with the channel region interposed therebetween. Each of the source region and the drain region is formed of a semiconductor material implanted with n-type or p-type impurities. The channel region overlapping the gate electrode 43 may be formed of a semiconductor material into which n-type or p-type impurities are not implanted.

The gate electrode 43 of the thin film transistor TFT may be provided to have the same width as the channel region of the active layer 37 to overlap the channel region of the active layer 37 with the gate insulating film 41 interposed therebetween. The gate insulating film 41 overlaps the channel region of the active layer 37 in the same pattern as the gate electrode 43. For example, the gate electrode 43 may be a single layer or multilayer structure formed of at least one selected from the group consisting of molybdenum (Mo), aluminum (Al), chromium (Cr), gold (Au), titanium (Ti), nickel (Ni), neodymium (Nd), copper (Cu), and alloys. The gate insulating film 41 may be formed of an inorganic insulating material, for example, a silicon oxide ($SiO_x$) film, a silicon nitride ($SiN_x$) film, a silicon oxynitride ($SiO_xN_y$) film, or a multilayer film thereof.

The light-shielding layer 21 on the substrate 10 is disposed below the active layer 37 to overlap at least the channel region of the active layer 37 of the thin film transistor TFT. The light-shielding layer 21 prevents external light from penetrating the substrate 10 and being transmitted to the thin film transistor TFT. For example, the light-shielding layer 21 may be formed as a single layer of a metal material, such as molybdenum (Mo), titanium (Ti), aluminum-neodymium (AlNd), aluminum (Al), chromium (Cr), or an alloy thereof, or as a multilayer structure using the same.

Referring to FIG. 5A, the bank 67 according to one embodiment may be provided on the overcoat layer 50 to fill the contact hole CH and cover the entirety of the thin film transistor area TA (in FIG. 1) in which the thin film transistor TFT is provided. Accordingly, in the present disclosure, the bank 67 covers the contact hole CH and the thin film transistor TFT, the intermediate layer 63 is not provided on the first electrode 61, and thus, it is possible to prevent light from being emitted in the area where the contact hole CH and the thin film transistor TFT are provided. In this case, the bank 67 may be formed of a type of organic insulating film. For example, the bank 67 according to one embodiment may be formed of any one of photo acryl, polyimide, a benzocyclobutene resin, and acrylate.

Referring to FIG. 5B, the bank 167 according to another embodiment may be provided on an area of the first electrode 61 corresponding to the contact hole CH, an area of the first electrode 61 adjacent to the contact hole CH, and the end of the first electrode 61. As such, the present disclosure may apply the liner-type bank 167 to provide the bank 167 in a minimum area. In this case, the bank 167 may be formed of a type of inorganic insulating film so that it can be easily formed thinly. For example, the bank 167 according to another embodiment may be formed of any one of a silicon oxide ($SiO_x$) film, a silicon nitride ($SiN_x$) film, and a silicon oxynitride (Si-$O_xN_y$) film.

Further, a protective film and an encapsulation layer may be further provided on the bank 67 or 167 and the light emitting element 60. The protective film may include a capping layer including an organic insulating material to improve optical characteristics of the second electrode 65 and protect the second electrode 65 and/or an inorganic protective film including an inorganic insulating material. The encapsulation layer may be provided in the form of a stack of one or more pairs of an organic encapsulation layer and an inorganic encapsulation layer provided to cover the entirety of the active area and the non-active area on the substrate 10. The encapsulation layer may prevent oxygen and moisture from penetrating into the light emitting elements, thereby being capable of improving the lifespan of the light emitting display device. Here, the encapsulation layer may be formed as an encapsulation substrate, and the encapsulation substrate and the substrate 10 provided with the thin film transistors TFT may be bonded to each other by interposing an adhesive layer having adhesive properties therebetween, or may be bonded to each other through a sealant applied to the edges of the encapsulation substrate and the substrate 10 in the state in which the encapsulation substrate and the substrate 10 face each other.

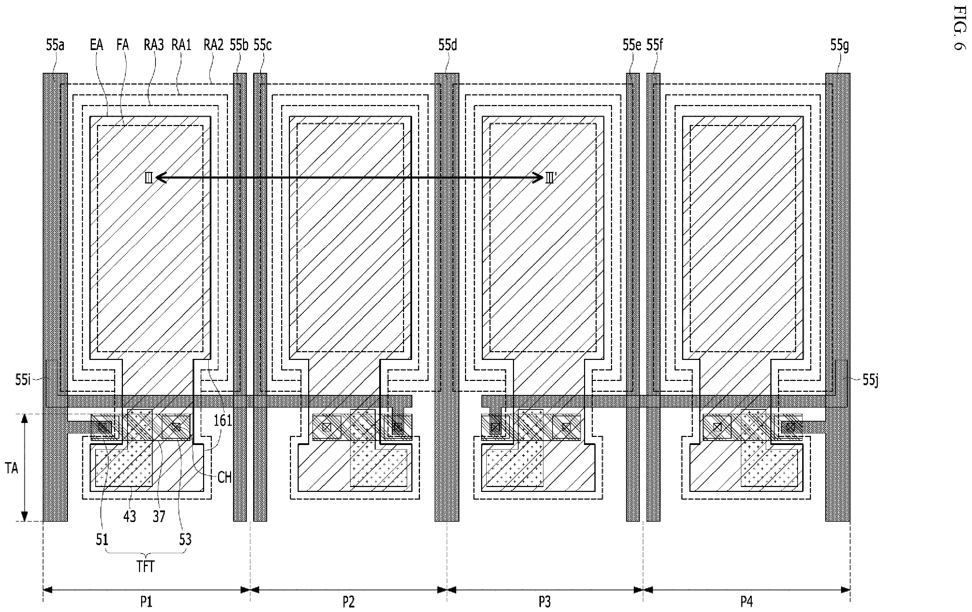

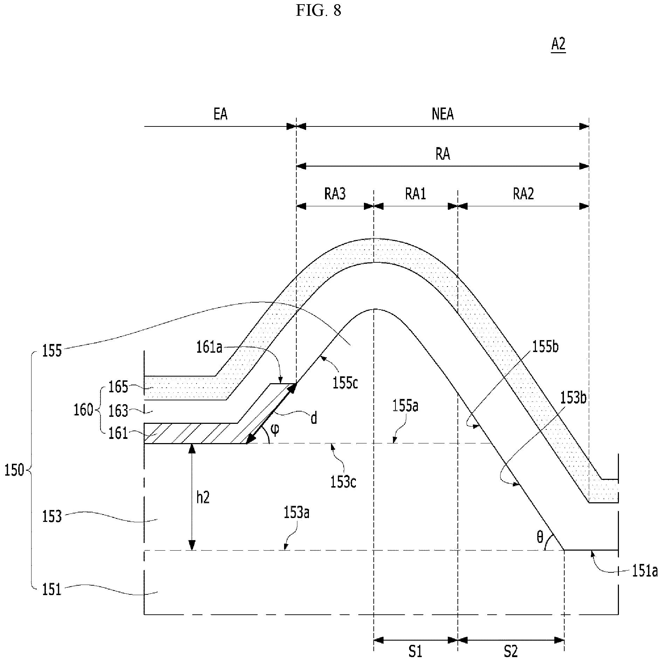

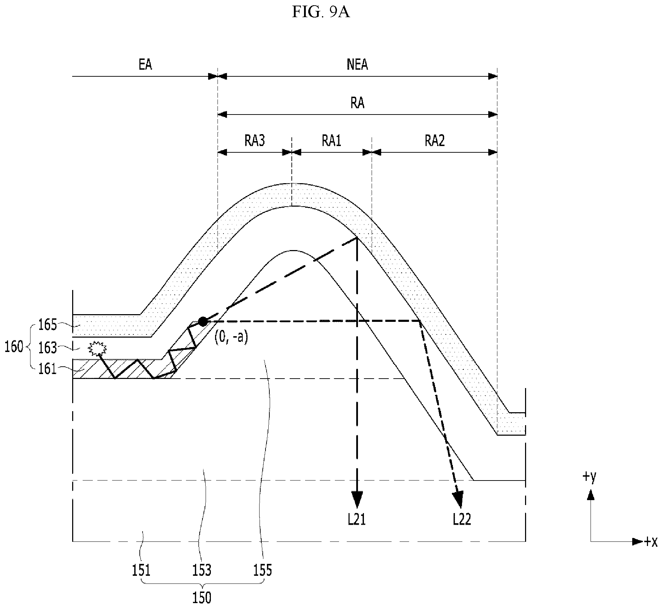

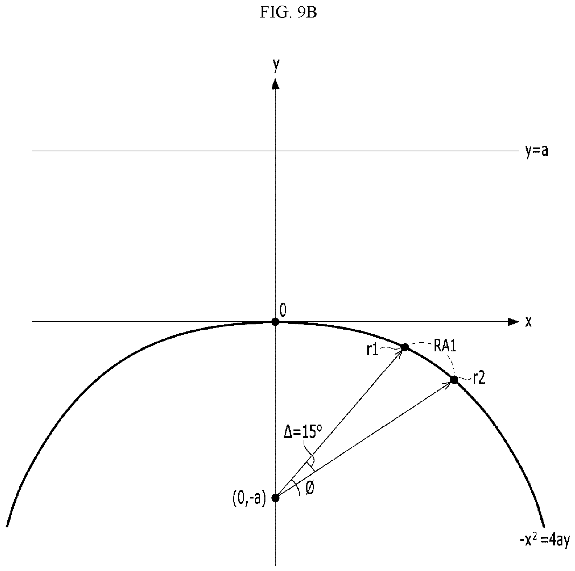

Next, FIGs. 6 to 9B are views showing a light emitting display device according to a second embodiment. FIG. 6 is a plan view of the light emitting display device according to the second embodiment. FIG. 7 is a cross-sectional view taken along line III-III' of FIG. 6. FIG. 8 is an enlarged view of area A2 of FIG. 7 according to an embodiment of the present disclosure. FIG. 9A is a diagram showing an optical waveguide path of the light emitting display device according to an embodiment of the present disclosure. FIG. 9B is a diagram plotting a parabolic area of a second electrode in a coordinate system according to an embodiment of the present disclosure. Hereinafter, the light emitting display device according to the second embodiment will be described while omitting a description of components which are the same as those of the previous embodiment.

Referring to FIG. 6, the light emitting display device of the present disclosure according to the second embodiment may have an emission area EA which is wider than a flat area FA (e.g., a portion of the emission area EA can extend along an inclined area). Further, a third reflection area RA3, a first reflection area RA1, and a second reflection area RA2 may be sequentially provided outside the emission area EA. The third reflection area RA3 may be provided outside the emission area EA along the edge of the emission area EA. The first reflection area RA1 may be provided outside the third reflection area RA3, and may not be provided outside an area of a first electrode 161 where a thin film transistor area TA is provided. The second reflection area RA2 may be provided outside the first reflection area RA1, and may not be provided outside the area of the first electrode 161 where the thin film transistor area TA is provided. The first reflection area RA1 and the second reflection area RA2 are components for light extraction, and may not be provided in the thin film transistor area TA, which may be an area in which light is not extracted in some cases. However, the present disclosure is not limited thereto, and the first reflection area RA1 and the second reflection area RA2 may be provided along all edge areas of the first electrode 161. In addition, the second reflection area RA2, which is located at the outermost position among the first to third reflection areas RA1, RA2, and RA3, may partially overlap at least two lines (or wirings) of first to seventh lines 55a, 55b, 55c, 55d, 55e, 55f, and 55g arranged in one direction.

Referring to FIG. 7, the light emitting display device of the present disclosure according to the second embodiment may have an overcoat layer 150 including a first overcoat layer 151, a second overcoat layer 153, and a third overcoat layer 155. That is, the overcoat layer 150 according to the second embodiment may further include the third overcoat layer 155 which protrudes corresponding to a specific area, on the second overcoat layer 53 of the overcoat layer 50 according to the first embodiment. For example, the third overcoat layer 155 can provide ridges or raised portions disposed on opposite sides of the first concave area CA1 (e.g., a type of double hump structure or a double ridged structure).

The light emitting display device of the present disclosure according to the second embodiment may comprises a first subpixel (P1) and a second subpixel (P2) disposed on a substrate (10), an overcoat layer (153) disposed between the first and second subpixels (P1, P2) and the substrate (10), the overcoat layer (153) including a concave area (RA) between the first subpixel (P1) and the second subpixel (P2), first electrodes (161) disposed in the first subpixel (P1) and the second subpixel (P2), a light emitting layer (163) disposed across the first subpixel (P1), the concave area (RA) of the overcoat layer (153) and the second subpixel (P2) and a second electrode (165) disposed on the light emitting layer (165) and across the first subpixel (P1), the concave area (RA) of the overcoat layer (153) and the second subpixel (P2). A portion of the second electrode (165) disposed in the concave area (RA) of the overcoat layer (153) may be closer to the substrate (10) than the first electrodes (161) of the first and second subpixels (P1, P2).

The concave area (RA: RA1, RA2) may surround at least three sides of the first subpixel (P1) in a plan view of FIG. 6.

An outer edge of the first electrode in the first subpixel may have an inclined surface or a tapered shape. An outer edge of the first electrode in the second subpixel may have an inclined surface or a tapered shape.

A portion of the second electrode overlapping with the concave area may have a curved shape or a parabolic shape, and is configured to reflect light emitted from the light emitting layer in a direction toward the substrate.

The overcoat layer may further include a first ridged portion disposed between the first subpixel and the second subpixel and a second ridged portion disposed between the first subpixel and the second subpixel. The concave area may be between the first and second ridged portions of the overcoat layer.

A first peak of the first ridged portion of the overcoat layer and a second peak of the second ridged portion of the overcoat layer (153) are located farther away from the substrate (10) than both of the first electrode (161) in the first subpixel (P1) and the first electrode (161) in the second subpixel (P2).

The overcoat later 150 may be provided on the entirety of an active area and a non-active area on the substrate 10. The overcoat layer 50 may cover color filters 71, 73, and 75, a plurality of lines 55a, 55b, 55c, 55d, 55e, 55f, 55g, 55i, and 55j (in FIG. 6), transistors TFT (in FIG. 6), etc. The overcoat layer 150 may be formed to have a thickness sufficient to flatten or planarize surface steps caused by components such as the transistors TFT on the substrate 10.

The first to third overcoat layers 151, 153, and 155 may be formed of the same material in the same process. Alternatively, the first to third overcoat layers 151, 153, and 155 may be formed of the same material in different processes. In some cases, the first to third overcoat layers 151, 153, and 155 may be formed of different materials.

The overcoat layer 150 may have the flat areas FA, first concave areas CA1, and second concave areas CA2 between the flat areas FA and the first concave areas CA1. Here, the second concave area CA2 may have a second inclined surface extending from the flat area FA. The second inclined surface of the second concave area CA2 and the first inclined surface of the first concave area CA1 may be inclined in different directions and protrude from the first overcoat layer 151 to form a convex shape. Further, the first electrode 161 may be provided on the second inclined surface of the second concave area CA2, and a reflected light emission area may be provided on the second inclined surface of the second concave area CA2 which does not overlap the first electrode 161.

The flat area FA of the overcoat layer 150 is an area in which the surface of the second overcoat layer 153 is flat, and the first electrode 161 conductively connected to the thin film transistor TFT is provided thereon. As shown in FIG. 7, the first electrode 161 may have an area which completely overlaps the flat area FA of the second overcoat layer 153 exposed from the third overcoat layer 155, and overlaps a portion of the second concave area CA2.

The first concave area CA1 of the overcoat layer 150 may be provided between adjacent flat areas FA. Further, the second concave area CA2 may be interposed between the first concave area CA1 of the overcoat layer 150 and the flat area FA adjacent thereto. The first and second concave areas CA1 and CA2 described in the present disclosure are areas which surround the emission area EA, and may be components differing from a hole for contact. Also, the first and second concave areas CA1 and CA2 can surround three or more sides of a corresponding subpixel in a plan view.

The first concave area CA1 according to the second embodiment may be an area which is recessed toward a surface 151a of the first overcoat layer 151 along a side surface 153b of the second overcoat layer 153 and a first surface 155b of the third overcoat layer 155, which is formed continuously with the side surface 153b. The first concave area CA1 may overlap the non-emission area NEA, and may overlap the reflection area RA outside the emission area EA.

The second concave area CA2 may be an area of a third surface 155c of the third overcoat layer 155 having an inclination in a different direction from the first surface 155b. A portion of the first electrode 161 extending from the flat area FA may be provided on the second concave area CA2, and the second concave area CA2 may overlap a portion of the emission area EA.

Referring concurrently to FIG. 8, the first overcoat layer 151 may be provided on the entire surface of the substrate 10, and may come into contact with the surface of the passivation layer 40 and the surfaces of the first, third, and fourth color filters 71, 73, and 75. The surface 151a of the first overcoat layer 151 may be made flat by flattening steps on the substrate 10.

The second overcoat layer 153 may be provided on the first overcoat layer 151 to correspond to each of the plurality of subpixels P1, P2, P3, and P4. The second overcoat layer 513 may be formed to protrude from the surface 151a of the first overcoat layer 151. The second overcoat layer 153 may be independently provided in each of the plurality of subpixels P1, P2, P3, and P4. Specifically, the second overcoat layer 153 may include a lower surface 153a in contact with the surface 151a of the first overcoat layer 151, an upper surface 153c opposite to the lower surface 153a, and the side surface 153b configured to connect the lower surface 153a and the upper surface 153c. Here, the side surface 153b of the second overcoat layer 153 may overlap at least the second reflection area RA2.

The upper surface 153c of the second overcoat layer 153 may partially overlap the flat area FA of the overcoat layer 150. For example, the flat area FA may overlap the central portion of the upper surface 153c of the second overcoat layer 153. The third overcoat layer 155 may be provided on the upper surface 153c which does not overlap the flat area FA of the second overcoat layer 153. The upper surface 153c of the second overcoat layer 153 may overlap a portion of the reflection area RA in addition to the emission area EA of each subpixel. The reflection area RA partially overlapping the upper surface 153c of the second overcoat layer 153 may include the first and third reflection areas RA1 and RA3.

The side surface 153b of the second overcoat layer 153 may overlap at least the second reflection area RA2. The side surface 153b of the second overcoat layer 153 may be provided between the surface 151a of the first overcoat layer 151 and the first surface 155b of the third overcoat layer 155. Further, the side surface 153b of the second overcoat layer 153 may form a first angle $\theta$ with the lower surface 153a. The first angle $\theta$ will be described in detail in FIGs. 9A and 9B.

The third overcoat layer 155 may be provided on the upper surface 153c of the second overcoat layer 153. The third overcoat layer 155 may be provided along the edge of the upper surface 153c of the second overcoat layer 153, and the flat area FA may be provided within the area in which the third overcoat layer 155 is provided. Further, the third overcoat layer 155 may be provided between the first electrode 161 and the second overcoat layer 153 while the first electrode 161 is provided on a portion of the inner surface of the third overcoat layer 155. The third overcoat layer 155 may have the first surface 155b and the third surface 155c serving as two side surfaces, and a second surface 155a serving as a lower surface between the two side surfaces.

The second surface 155a of the third overcoat layer 155 may come into contact with the upper surface 153c of the second overcoat layer 153. The second surface 155a of the third overcoat layer 155 may have an area which overlaps the emission area EA and an area which overlaps the non-emission area NEA.

The first surface 155b of the third overcoat layer 155 may be connected to the side surface 153b of the second overcoat layer 153. The first surface 155b of the third overcoat layer 155 may overlap the first reflection area RA1.

The third surface 155c of the third overcoat layer 155 may come into contact with the lower portion of the edge of the first electrode 161, and may have an inclination of a second angle φ with respect to the second surface 155a. The second angle φ may be set considering a degree at which the first electrode 161 is bent from the flat area to the second concave area CA2. The optical waveguide mode proceeding within the first electrode 161 may proceed to the end 161a of the first electrode 161 along the inside of the first electrode 161 in the flat area FA, which has a relatively large area. At this time, the optical waveguide mode within the first electrode 161 in the flat area FA may proceed in a direction parallel to the flat area FA, and in this case, when the edge of the first electrode 161 is sharply bent, light travelling the direction parallel to the flat area FA may not reach the end 161a of the first electrode 161, and may proceed directly to the overcoat layer 155. Therefore, the second angle φ may be set to be in the range of 15° to 35° to control the degree of bending the first electrode 161 in consideration of the characteristics of the optical waveguide mode.

The inner surface of the overcoat layer 150 including both the side surface 153b of the second overcoat layer 153 and the first surface 155b of the third overcoat layer 155 in the first concave area CA1 may include a first side surface part S1 and a second side surface part S2. The inner surface of the overcoat layer 150 in the first side surface part S1 and the inner surface of the overcoat layer 150 in the second side surface part S2 may be formed to have different shapes.

The inner surface of the overcoat layer 150 in the second side surface part S2 may be formed in a corresponding shape so that the second electrode 165 forms a shape capable of reflecting the optical waveguide mode in the lateral direction of the substrate 10. The inner surface of the overcoat layer 150 in the second side surface part S2 may be formed as a straight line. Further, the inner surface of the overcoat layer 150 in the second side surface part S2 may be formed at a first angle θ with the lower surface 153a of the second overcoat layer 153. Here, the first angle θ may be between 27.5° and 35°, considering the light distribution characteristics of the optical waveguide mode which will be described below.

Meanwhile, as a vertical distance h2 between the upper surface 153c and the lower surface 153a of the second overcoat layer 153 increases, a straight area or straight sloped portion may increase. Due to the characteristics of a parabola, a straight section may increase as the vertical distance h2 increases. Further, since the increase in the straight section through the increase in the vertical distance h2 leads to an increase in a viewing angle extraction area, the non-emission area NEA increases compared to the emission area EA and may thus reduce the lifespan of the light emitting display device, and thus, in order to prevent this problem, the vertical distance h2 may be set to an appropriate value or less. For example, the vertical distance h2 may be set to 1 μm or less.

The light emitting display device according to the present disclosure may determine the shapes of layers included in light emitting elements 160 deposited on the overcoat layer 150 depending on the shapes of the side surface 153b of the second overcoat layer 153 and the first surface 155b of the third overcoat layer 155. The light emitting element 160 including the first electrode 161, an intermediate layer 163, and the second electrode 165 may be provided on the overcoat layer 150. The layers included in the light emitting element 160 may be formed of very thin organic films or metals having good step coverage, and may be deposited along the surface shape of the overcoat layer 150.

The first electrode 161 may be provided in each of the plurality of subpixels P1, P2, P3, and P4, and may be provided on the upper surface 153c of the second overcoat layer 153 and the third surface 155c of the third overcoat layer 155. The first electrode 161 may be provided on a portion of the third surface 155c of the third overcoat layer 155 along the upper surface 153c of the second overcoat layer 153 exposed by the third overcoat layer 155. Providing the first electrode 161 to expose the upper portion of the third surface 155c of the third overcoat layer 155 may be to provide a basis for the second electrode 165 formed along the first surface 155b of the third overcoat layer 155 while minimizing the portion of the first electrode 161 which is bent upward. Further, providing the first electrode 161 to expose the upper portion of the third surface 155c of the third overcoat layer 155 may be an optical condition to reflect light emitted from the end 161a along the optical waveguide path in the first electrode 161 by the inner surface of the second electrode 165 to extract the light to the front surface of the substrate 10 from an optical point of view.

Here, when light traveling in the first electrode 161 in the flat area FA is bent in the second concave area CA2, the traveling direction of the light is changed, and it may be difficult for the light to reach the end 161a of the first electrode 161, thereby causing difficulty in emitting the optical waveguide mode. Accordingly, in the present disclosure, in order to emit light in the optical waveguide mode from the end 161a of the first electrode 161, the upwardly bent portion of the first electrode 161 may be minimized. In general light emitting display devices, the upwardly bent portion of the first electrode 161 according to the present disclosure, i.e., an area of the first electrode 161, which comes into contact with the third surface 155c of the third overcoat layer 55, may have a length d of about 2 μm.

The second electrode 165 on the intermediate layer 163 may be formed on the entire surface of the substrate 10 through a common mask, e.g., laid down as a common layer. The second electrode 165 may be formed to have higher reflection efficiency than the first electrode 161 to reflect light generated from the intermediate layer 163.

The second electrode 165 may be provided along the surface shape of the overcoat layer 150. The second electrode 165 may be located along the side surface 153b of the second overcoat layer 153 and the first surface 155b of the third overcoat layer 155 in the reflection area RA to surround the end 161a of the first electrode 161. Accordingly, the second electrode 165 provided in the reflection area RA may reflect light traveling laterally, among light generated from the emission area EA, toward the substrate 10.

As described above with reference to FIG. 10, the optical waveguide mode may have a light intensity of 1 or less at angles between 0° and 45°, and may have a light intensity of 2 or more at angles between 45° and 90°. According to this, it may be seen that the optical waveguide mode mostly proceeds at angles from 75° to 90°. Particularly, the optical waveguide mode may have a light intensity of 2 at an angle of about 75°, which exhibits the best efficiency.

The direction in which the optical waveguide mode is emitted from the first electrode 161 according to the second embodiment may be raised upward by the second angle φ compared to the first embodiment. That is, an angle range with optimal efficiency in the light distribution of the optical waveguide mode may be "75°+φ" to "90°+φ". Accordingly, the present disclosure may have the following second electrode 165 configured to extract light in the optical waveguide mode for an area of "75°+φ" to "90°+φ", in which the efficiency of the optical waveguide mode is the best, to the substrate 10.

Referring to FIG. 9A, the second electrode 165 is formed in a parabola which satisfies the following Equation 1 at least in the first reflection area RA1, thereby being capable of reflecting light in the optical waveguide mode among light, which is generated from the emission area EA and travels laterally, in a forward direction L21 of the substrate 10. That is, referring to FIG. 9A, the optical waveguide mode emitted from one focus (0,-a) of the end 161a of the first electrode 161 may proceed in the forward direction L21 of the substrate 10, which is perpendicular to the substrate 10, by the second electrode 165 corresponding to the first reflection area RA1.

$$\text{Equation 1: } -x^2 = 4ay \text{ (a is a constant greater than 0)}$$

Referring concurrently to FIG. 9B, Equation 1 may satisfy conditions in which the focus has the coordinates (0,-a) at the end 161a of the first electrode 161, y=a is a directrix, and a is a constant greater than 0. Here, the x-axis may be parallel to the first electrode 161. Further, the end 61a of the first electrode 60 may be a point from which the optical waveguide mode is emitted, and the point from which the optical waveguide mode is emitted may mean the focus (0,-a) for the parabolic equation of Equation 1. Here, the focus (0,-a) according to the second embodiment may have different coordinates from the focus (0,-a) according to the first embodiment. r1 and r2 shown in FIG. 9B are points where light in the optical waveguide mode traveling in the 90° direction and light in the optical waveguide mode travelling in the 75° direction shown in FIG. 10 meet a parabola following Equation 1, respectively. A parabolic area between r1 and r2 may have the effect of extracting the optical waveguide mode in the forward direction of the substrate 10, which is the direction perpendicular to the substrate 10. That is, the second electrode 165 provided in the first reflection area RA1 of the present disclosure may have a parabolic shape corresponding to the reflection area RA1 shown in FIG. 9B. Accordingly, in the present disclosure, the optical waveguide mode emitted from the end 161a of the first electrode 161 is extracted in the forward direction of the substrate 10 through the second electrode 165 provided in the first reflection area RA1 to surround the end 161a of the first electrode 161, thereby further improving forward light extraction efficiency of the light emitting display device.

An area of the second electrode 165 corresponding to the second reflection area RA2 may reflect the optical waveguide mode in a lateral direction L22 of the substrate 10. The straight area of the second electrode 165 overlapping the second reflection area RA2 of the second electrode 165 may be a straight section of the parabola extending toward the second reflection area RA2 depending on Equation 1 for the parabola of the second electrode 165 overlapping the first reflection area RA1. Since the area of the second electrode 165 corresponding to the second reflection area RA2 is formed along the shape of the side surface 153b of the second overcoat layer 153, the angle of such a straight area of the second electrode 165 with the substrate 10 may be the first angle θ. The first angle θ may satisfy the following Equation 3.

$$\text{Equation 3: } \theta = \{180 - (\alpha + \varphi)\}/2$$

Here, α+φ may mean the progress angle of the optical waveguide mode in FIG. 10 in consideration of the second angle φ. In the present disclosure, the optical waveguide mode has the best efficiency at angles of 75° to 90°, and the optimal condition of the first angle θ may be derived by substituting these angles for α and substituting, for example, 35°, which is the optimal angle as the second angle φ, for φ. By substituting 75° and 90° for α respectively and substituting 35° for φ in Equation 2, the optimal condition of the first angle θ may be the range of 27.5° to 35°. That is, the light emitting display device of the present disclosure may extract the optical waveguide mode with the highest efficiency in the forward direction of the substrate 10, when the angle between the area of the second electrode 165 corresponding to the second reflection area RA2 and the substrate 10 is in the range of 27.5° to 35°. In addition, the light emitting display device of the present disclosure may achieve the maximum efficiency in extraction of the optical waveguide mode in the forward direction of the substrate 10, when the angle between the area of the second electrode 165 corresponding to the second reflection area RA2 and the substrate 10 is 35°. However, the first angle θ of the present disclosure is not limited thereto, and may be less than 27.5° or greater than 35° to extract light in the optical waveguide mode.

An area of the second electrode 165 corresponding to the third reflection area RA3 may guide the optical waveguide mode in the forward direction of the substrate 10. When light as an optical waveguide mode component emitted from the first electrode 161 is reflected by the area of the second electrode 165 in the third reflection area RA3, the light may be reflected at half the exit angle of the light, and reach the area of the second electrode 65 corresponding to the first reflection area RA1 or the second reflection area RA2. As a result, the light as the optical waveguide mode component reflected by the area of the second electrode 165 in the third reflection area RA3 may be reflected again by the area of the second electrode 165 corresponding to the first reflection area RA1 or the second reflection area RA2, and may be emitted in the forward direction of the substrate 10. Therefore, the area of the second electrode 165 in the third reflection area RA3 may be located above the first electrode 161. Therefore, the area of the second electrode 165 in the third reflection area RA3 may indirectly reflect and extract light traveling in the upward direction opposite to the front surface of substrate 10, among light generated from the emission area EA, toward the substrate 10.

As such, the light emitting display device of the present disclosure is configured such that the second electrode 165 surrounds the end 161a of the first electrode 161, and emits the optical waveguide mode, emitted from the end 61a of the first electrode 61, toward the substrate 10. Particularly, since the parabolic area of the second electrode 165, which corresponds to the first reflection area RA1 and satisfies Equation 1, may reflect the optical waveguide mode in the forward direction L21 (in FIG. 9A) of the substrate 10, the light emitting display device according to the present disclosure may have the effect of significantly improving forward light extraction efficiency. Further, since the straight area of the second electrode 615 corresponding to the second reflection area RA2 may reflect the optical waveguide mode in the lateral direction L22 (in FIG. 9A) of the substrate 10, the light emitting display device according to the present disclosure may have the effect of improving a viewing angle (e.g., the subpixels can be brighter and have a wider viewing angle, reduce power consumption, and be packed closer together).

Further, the light emitting display device of the present disclosure according to the second embodiment has the structure including the flat areas FA, the first concave areas CA1, and the second concave areas CA2 to bend the edge of the first electrode 161 upwardly toward the second concave area CA2, thereby raising the light exit angle of the optical waveguide mode by the second angle $\varphi$, and thus enabling the first angle $\theta$ to be implemented as a low angle compared to the first embodiment. Accordingly, the light emitting display device of the present disclosure according to the second embodiment may implement a relatively low angle tapered structure. In other words, since the edges of the first electrode 161 are slightly bent upward, a better exit angle can be provided for light exiting the first electrode 161 due to the wave guide mode and this light can be incident on the parabolic portion of the second electrode 165 at an optimal angle to be optimally directed out of the device and towards a user's eyes.

In addition, the light emitting display device of the present disclosure minimizes the bank to correspond to the first electrode and the contact hole of the thin film transistor, thereby being capable of reducing a non-opening portion compared to a conventional structure having a bank provided on the edge of a first electrode, and thus improving the lifespan of the light emitting display device.

As is apparent from the above description, a light emitting display device of the present disclosure has the following effects.

First, in the light emitting display device of the present disclosure, the side surface of an overcoat layer is formed in a parabola, and thus, a second electrode formed along the side surface of the overcoat layer may surround the end of a first electrode in a parabolic shape. Since the second electrode surrounds the end of the first electrode in the parabolic shape, the light emitting display device of the present disclosure may extract an optical waveguide mode in the forward direction of a substrate, thereby being capable of improving forward light extraction efficiency.

Second, in the light emitting display device of the present disclosure, the overcoat layer has a straight area of the side surface under the parabolic area of the side surface, and thus, the second electrode formed along the side surface of the overcoat layer may further include a straight area. Accordingly, the light emitting display device of the present disclosure may extract light trapped in the optical waveguide mode, among light generated from an intermediate layer between the first electrode and the second electrode, in the lateral direction of the substrate, thereby being capable of improving viewing angle characteristics.

Third, the light emitting display device of the present disclosure minimizes a bank so that the bank is provided in an area provided with a thin film transistor a contact hole of the first electrode, thereby being capable of improving an opening and thus improving the lifespan of the light emitting display device.

Fourth, in the light emitting display device of the present disclosure, the second electrode extracts the optical waveguide mode to the outside of the substrate through the shape of the side surface of the overcoat layer, and may thus improve light extraction efficiency without any separate element, thereby being capable of reducing production energy. Accordingly, the light emitting display device according to the present disclosure has environmental, social, and governance (ESG) effects in terms of environmental friendliness and process optimization.

The effects of the present disclosure are not limited to the effect mentioned above, and other effects not mentioned will be clearly understood by those skilled in the art from the above description.

It will be apparent to those skilled in the art that various modifications and variations can be made in the present disclosure without departing from the scope of the disclosure. Thus, it is intended that the present disclosure cover the modifications and variations of the present disclosure provided they come within the scope of the appended claims and their equivalents.

**Claims**

1. A light emitting display device comprising:

    a substrate (10) comprising a plurality of subpixels (P1, P2, P3, P4);
    an overcoat layer (50, 150) provided on the substrate (10), the overcoat layer (50, 150) comprising a flat area (FA) to overlap an emission area (EA) of each of the plurality of subpixels (P1, P2, P3, P4) and a first concave area (CA1) to surround the flat area (FA) and overlap a reflection area (RA) of each of the plurality of subpixels (P1, P2, P3, P4);
    a first electrode (61, 161) on the flat area (FA) of the overcoat layer (50, 150);
    an intermediate layer (63, 163) provided on the overcoat layer (50, 150) and the first electrode (61, 161); and
    a second electrode (65, 165) provided on the intermediate layer (63, 163), the second electrode (65, 165) located along the first concave area (CA1) of the overcoat layer (50, 150) to surround an end of the first electrode (61, 161),
    wherein the second electrode (65, 165) has higher reflectance than the first electrode (61, 161).

2. The light emitting display device according to claim 1,
    wherein the overcoat layer (50, 150) comprises:

    a first overcoat layer (51, 151) provided on an entire surface of the substrate (10); and
    a second overcoat layer (53, 153) provided on the first overcoat layer (51, 151), the second overcoat layer (53, 153) having a side surface (53b, 153b) which overlaps a reflection area (RA) of each of the plurality of subpixels (P1, P2, P3, P4),
    wherein:

       the first electrode (61, 161) is provided on an upper surface (53c, 153c) of the second overcoat layer (53, 153) at the emission area (EA) of each of the plurality of subpixels (P1, P2, P3, P4);
       the intermediate layer (63, 163) is provided on the first overcoat layer (51, 151), the second overcoat layer (53, 153), and the first electrode (61, 161);
       each of the plurality of subpixels (P1, P2, P3, P4) is configured such that the reflection area (RA) is located outside the emission area (EA); and
       the second electrode (65, 165) is located along the side surface (53b, 153b) of the second overcoat layer (53, 153) in the reflection area (RA) to surround an end of the first electrode (61, 161).

3. The light emitting display device according to claim 2, wherein the side surface (53b, 153b) of the second overcoat layer (53, 153) comprises:

    a first side surface part (S1) adjacent to the upper surface (53c, 153c) of the second overcoat layer (53, 153); and
    a second side surface part (S2) adjacent to a lower surface (53a, 153a) of the second overcoat layer (53, 153), the second side surface part (S2) having a different shape from the first side surface part (S1), wherein the first side surface part (S1) preferably comprises a curve in a cross-sectional view.

4. The light emitting display device according to claim 3, wherein the first side surface part (S1) comprises a parabola in a cross-sectional view.

5. The light emitting display device according to claim 4, wherein:

    the reflection area (RA) comprises a first reflection area (RA1) provided with an area of the second electrode (65, 165) to follow a shape of the parabola of the first side surface part (S1);
    the parabola satisfies a following Equation to have a focus of coordinates (0,-a) at the end of the first electrode (61, 161) and a directrix of y=a; and
    an x-axis is parallel to the first electrode (61, 161), and a y-axis passes through the focus of the coordinates (0,-a),

Equation: $-x^2=4ay$ (a is a constant greater than 0).

6. The light emitting display device according to any of claims 3 to 5, wherein the second side surface part (P2) comprises a straight line in a cross-sectional view.

7. The light emitting display device according to claim 6, wherein:

   a first angle (θ) is between the second side surface part (S2) of the second overcoat layer (53, 153) and the lower surface (53a, 153a) of the second overcoat layer (53, 153); and
   an angle between the first side surface part (S1) of the second overcoat layer (53, 153) and the lower surface (53a, 153a) of the second overcoat layer (53, 153) is smaller than the first angle (θ).

8. The light emitting display device according to any of the preceding claims, wherein the upper surface (53c, 153c) of the second overcoat layer (53, 153) comprises an area to overlap the first electrode (61, 161) and/or

   wherein the end of the first electrode (61, 161) becomes thinner as a distance from a center of the first electrode (61, 161) increases, and/or
   the light emitting device further comprising color filters (71, 73, 75) between the first overcoat layer (51, 151) and the substrate (10) at the plurality of subpixels (P1, P2, P3, P4),
   wherein each of the color filters (71, 73, 75) overlap the emission area (EA) and the reflection area (RA).

9. The light emitting display device according to claim 2, further comprising a third overcoat layer (155) between the second overcoat layer (153) and the first electrode (161),

   wherein the third overcoat layer (155) comprises a first surface (155b) connected to the side surface (153b) of the second overcoat layer (153),
   wherein the second electrode (165) is located along the first surface (155b) of the third overcoat layer (155) in the reflection area (RA).

10. The light emitting display device according to claim 9, wherein the side surface (153b) of the second overcoat layer (153) and the first surface (155b) of the third overcoat layer (155) have different shapes, wherein the first surface (155b) of the third overcoat layer (155) preferably comprises a curve in cross-sectional view.

11. The light emitting display device according to claim 10, wherein the first surface (155b) of the third overcoat layer (155) comprises a parabola.

12. The light emitting display device according to claim 11, wherein:

   the reflection area (RA) comprises a first reflection area (RA1) provided with an area of the second electrode (165) to follow a shape of the parabola of the first surface (155b);
   the parabola satisfies a following Equation to have a focus of coordinates (0,-a) at the end of the first electrode (161) and a directrix of y=a; and
   an x-axis is parallel to the first electrode (161), and a y-axis passes through the focus of the coordinates (0,-a),

Equation: $-x^2=4ay$ (a is a constant greater than 0).

13. The light emitting display device according to claim 12, wherein the third overcoat layer (155) further comprises:

   a second surface (155a) to contact with the upper surface (153c) of the second overcoat layer (153); and
   a third surface (155c) to contact with a lower portion of an edge of the first electrode (161) and to have a second angle (φ) with the second surface (155a).

14. The light emitting display device according to any of claims 9 to 13, wherein the side surface (153b) of the second overcoat layer (153) comprises a straight line in a cross-sectional view.

15. The light emitting display device according to claim 14, wherein a first angle ($\theta$) is between the side surface (153b) of the second overcoat layer (153) and a lower surface (153a) of the second overcoat layer (153); and
an angle between the first surface (155b) and the second surface (155a) of the third overcoat layer (155) is smaller than the first angle ($\theta$).

Fig. 1

FIG. 2

FIG. 3

FIG. 4A

FIG. 4B

FIG. 5A

FIG. 5B

FIG. 6

Fig.7

EP 4 529 397 A1

30

FIG. 8

A2

FIG. 9A

FIG. 9B

FIG. 10

WG mode distribution

Europäisches
Patentamt

European
Patent Office

Office européen
des brevets

# EUROPEAN SEARCH REPORT

**Application Number**

EP 24 20 1539

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 9 082 997 B2 (SAMSUNG DISPLAY CO LTD [KR]) 14 July 2015 (2015-07-14) * claims 1-13; figure 5 * ----- | 1-15 | INV. H10K59/122 H10K59/124 H10K59/80 |
| X | US 10 056 447 B2 (LG DISPLAY CO LTD [KR]) 21 August 2018 (2018-08-21) * claims 1-10; figure 5 * ----- | 1-15 | |

**TECHNICAL FIELDS SEARCHED (IPC)**

H10K

The present search report has been drawn up for all claims

| Place of search | Date of completion of the search | Examiner |
|---|---|---|
| The Hague | 29 January 2025 | Parashkov, Radoslav |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

...........................................................................

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 24 20 1539

This annex lists the patent family members relating to the patent documents cited in the above-mentioned European search report.
The members are as contained in the European Patent Office EDP file on
The European Patent Office is in no way liable for these particulars which are merely given for the purpose of information.

29-01-2025

| Patent document cited in search report | | Publication date | Patent family member(s) | | Publication date |
|---|---|---|---|---|---|
| US 9082997 | B2 | 14-07-2015 | CN | 104064579 A | 24-09-2014 |
| | | | JP | 6381878 B2 | 29-08-2018 |
| | | | JP | 2014183038 A | 29-09-2014 |
| | | | KR | 20140115194 A | 30-09-2014 |
| | | | TW | 201438221 A | 01-10-2014 |
| | | | US | 2014284563 A1 | 25-09-2014 |
| | | | US | 2015303407 A1 | 22-10-2015 |
| US 10056447 | B2 | 21-08-2018 | CN | 106601769 A | 26-04-2017 |
| | | | KR | 20170045460 A | 27-04-2017 |
| | | | US | 2017110522 A1 | 20-04-2017 |
| | | | US | 2018190751 A1 | 05-07-2018 |

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020230128334